(19) Europäisches Patentamt
European Patent Office
Office européen des brevets

(11) **EP 4 593 537 A1**

(12) **EUROPEAN PATENT APPLICATION**
published in accordance with Art. 153(4) EPC

(43) Date of publication:
**30.07.2025 Bulletin 2025/31**

(21) Application number: 23867933.6

(22) Date of filing: **16.08.2023**

(51) International Patent Classification (IPC):
*H05K 1/11* $^{(2006.01)}$       *H01L 23/12* $^{(2006.01)}$
*H01L 23/15* $^{(2006.01)}$       *H05K 1/16* $^{(2006.01)}$
*H05K 3/00* $^{(2006.01)}$

(52) Cooperative Patent Classification (CPC):
**H01L 23/12; H01L 23/15; H01L 23/32; H05K 1/11;
H05K 1/16; H05K 3/00**

(86) International application number:
**PCT/JP2023/029603**

(87) International publication number:
**WO 2024/062808 (28.03.2024 Gazette 2024/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.09.2022 JP 2022151675**

(71) Applicant: **Toppan Holdings Inc.
Tokyo 110-0016 (JP)**

(72) Inventor: **ISHII, Tomoyuki
Tokyo 110-0016 (JP)**

(74) Representative: **Plasseraud IP
104 Rue de Richelieu
CS92104
75080 Paris Cedex 02 (FR)**

(54)   **WIRING SUBSTRATE**

(57)   The present disclosure makes it difficult for disconnection to occur between a wiring layer provided on a glass substrate and TGVs provided in the glass substrate. A wiring board (1) includes a glass substrate (10) having first and second surfaces (S1, S2) and provided with through-holes; a first conductor layer (20) including a first copper layer (24) facing the first surface and a hydrofluoric acid resistant metal layer (21) interposed between them, and covering openings of the through-holes on the first surface side, the first conductor layer having recesses at positions of the through-holes in a surface on the glass substrate side, each recess having an opening with a contour wider than and surrounding the opening of the corresponding through-hole on the first surface side; and a second conductor layer (70) including an adhesion layer (72) covering the side walls of the through-holes, inner surfaces of the recesses, and regions of the second surface surrounding the openings of the through-holes on the second surface side, a seed layer (73) provided on the adhesion layer, and a second copper layer (74) provided on the seed layer, wherein a sum T1+T2 of a thickness T1 of the adhesion layer and a thickness T2 of the seed layer is greater than or equal to a thickness T3 of the hydrofluoric acid resistant metal layer.

FIG.2

**Description**

[Technical Field]

The present invention relates to wiring boards.

[Background Art]

Conventionally, for example, a packaging technique using through-silicon vias (TSVs) has been known as a packaging technique for large-scale integrated circuits (LSIs). Silicon substrates provided with TSVs, i.e., silicon interposers, are wiring boards connecting components having different inter-terminal distances, such as integrated circuit (IC) chips and printed circuit boards with different wiring design rules.

In silicon interposers, the silicon, which is a semiconductor, needs to be electrically insulated from the through-electrodes. Specifically, an insulation treatment is required to be performed on the silicon substrate after the through-holes are formed. Silicon substrates are expensive. Therefore, silicon interposers raise an issue of increase in production costs. In view of this, attention has been focused on glass interposers, which are obtained by forming through-glass vias (TGVs) or the like in an inexpensive, large-area glass substrate and dividing the substrate into individual pieces.

In the TGV technique, it is necessary to form through-holes in glass substrates. Various methods can be used for forming through-holes in glass substrates.

For example, as described in PTL 1, there is known a technique for forming through-holes in glass substrates by applying a laser beam using a pulsed YAG laser.

PTL 2 describes a method of forming fine holes in a photosensitive glass substrate. In this method, first, a photosensitive glass substrate is irradiated with ultraviolet light through a photomask to form latent images on the photosensitive glass substrate. The photosensitive glass substrate is then heat-treated to cause crystallization in the portions where the latent images are formed. Next, at the center of each portion where a latent image is formed, a hole smaller than the latent image is formed by laser irradiation. After that, the crystallized portions are selectively etched using hydrofluoric acid. In this way, holes larger than the holes formed by laser irradiation are produced.

PTL 3 describes a method of drilling holes in a glass plate using a pair of core drills coaxially arranged and facing each other with the glass plate sandwiched therebetween.

PTL 4 describes a method of simultaneously forming through-holes in a glass substrate and thinning the glass substrate by etching. In this method, the glass substrate is irradiated with a laser beam first to produce modified portions. Next, one surface of the glass substrate is etched using hydrofluoric acid to thin the glass substrate, while forming through-holes by removing the modified portions.

Glass interposers can also be provided with inductors or capacitors PTL 5 describes a glass core wiring board integrated with an LC filter which is a combination an inductor and a capacitor. In this wiring board, the capacitor has a structure called MIM (Metal/Insulator/Metal) in which a metal layer, a dielectric layer, and a metal layer are laminated in the thickness direction of the glass core substrate. In this wiring board, the inductor has a structure in which the helical axis is parallel to the major surface of the glass core substrate and helically extends passing through two rows of through-holes provided in the glass core substrate.

[Citation List]

[Patent Literature]

PTL 1: JP2000-61667A

PTL 2: JP2001-105398A

PTL3: JP54-126215A

PTL 4: WO2019/235617

PTL 5: JP2021-166257A

[Summary of the Invention]

The present invention aims to provide a technique with which disconnection is less likely to occur between a wiring layer provided on a glass substrate and TGVs provided in the glass substrate.

According to an aspect of the present invention, there is provided a wiring board including a glass substrate having a first surface and a second surface, which is to a rear of the first surface, and provided with one or more first through-holes each extending from the first surface to the second surface; a first conductor layer including a first copper layer facing the first surface, and a hydrofluoric acid resistant metal layer interposed between the first copper layer and the glass substrate and covering openings of the one or more first through-holes on the first surface side, the first conductor layer having recesses in a surface thereof at positions of the one or more first through-holes on the glass substrate side, each of the recesses having an opening whose contour is wider than and surrounding the opening of a corresponding one of the one or more first through-holes on the first surface side; and a second conductor layer including an adhesion layer covering the side walls of the one or more first through-holes, inner surfaces of the recesses, and regions of the second surface surrounding openings of the one or more first through-holes on the second surface side, a seed layer provided on the adhesion layer, and a second copper layer provided on the seed layer, wherein a sum T1+T2 of a thickness T1 of the adhesion layer and a thickness T2 of the seed layer is greater than or equal to a thickness T3 of the hydrofluoric acid resistant metal layer.

According to another aspect of the present invention, there is provided the wiring board according to the above aspect, wherein the hydrofluoric acid resistant metal layer is provided with one or more second through-holes at positions of the one or more first through-holes, and the one or more second through-holes form the recesses in the surface of the first conductor layer on the glass substrate side.

According to still another aspect of the present invention, there is provided the wiring board according to any of the above aspects, wherein the thickness T1 is greater than or equal to the thickness T3.

According to still another aspect of the present invention, there is provided the wiring board according to any of the above aspects, wherein the thickness T2 is greater than or equal to a sum T1+T3 of the thickness T1 and the thickness T3.

According to still another aspect of the present invention, there is provided the wiring board according to any of the above aspects, wherein the thickness T2 is 0.5 $\mu$m or less.

According to still another aspect of the present invention, there is provided the wiring board according to any of the above aspects, wherein the thickness T1 is in a range of 10 nm to 0.5 $\mu$m, the thickness T2 is in a range of 100 nm to 0.5 $\mu$m, and the thickness T3 is in a range of 10 nm to 0.5 $\mu$m.

According to still another aspect of the present invention, there is provided the wiring board according to any of the above aspects, further including a dielectric layer provided on the first conductor layer, and an upper electrode provided on the dielectric layer, wherein a portion of the first conductor layer facing the upper electrode serves as a lower electrode, and the upper electrode, the dielectric layer, and the lower electrode constitute a capacitor.

According to still another aspect of the present invention, there is provided the wiring board according to the above aspect, wherein the lower electrode covers at least one opening of the one or more first through-holes on the first surface side.

According to still another aspect of the present invention, there is provided the wiring board according to any of the above aspects, wherein the one or more first through-holes are a plurality of first through-holes, and part of the first conductor layer and part of the second conductor layer constitute a solenoid coil.

According to still another aspect of the present invention, there is provided the wiring board according to any of the above aspects, wherein the wiring board further includes a dielectric layer provided on the first conductor layer, and an upper electrode provided on the dielectric layer, a portion of the first conductor layer facing the upper electrode serves as a lower electrode, and the upper electrode, the dielectric layer, and the lower electrode constitute a capacitor; the one or more first through-holes are a plurality of first through-holes, and part of the first conductor layer and part of the second conductor layer constitute a solenoid coil; and the capacitor and the solenoid coil constitute an LC filter.

It should be noted that LC filters are also referred to as LC frequency filters. LC filters have a structure in which an inductor (L) and a capacitor (C) are combined with each other. LC filters utilize the resonance phenomenon to pass electrical signals of specific frequencies through circuits and block signals of other frequencies, and have functions as band-pass filters, low-pass filters, high-pass filters, or diplexers.

According to still another aspect of the present invention, there is provided the wiring board according to any of the above aspects, wherein the hydrofluoric acid resistant metal layer is made of a material selected from the group consisting of chromium, nickel, and nickel-chromium alloys.

According to still another aspect of the present invention, there is provided the wiring board according to any of the above aspects, wherein the adhesion layer is made of one or more materials selected from the group consisting of titanium, chromium, and nickel, or made of an oxide thereof, and the seed layer is made of copper.

According to still another aspect of the present invention, there is provided the wiring board according to any of the above aspects, wherein the wiring board serves as an interposer.

According to still another aspect of the present invention, there is provided a packaged device including the wiring board according to any of the above aspects, and functional devices mounted on the wiring board.

The term functional devices refers to devices which are activated with a supply of electrical power and/or electrical signals, devices which output electrical power and/or electrical signals due to external stimulation, or devices which are activated with a supply of electrical power and/or electrical signals and which output electrical power and/or electrical signals due to external stimulation. Functional devices may be, for example, in the forms of chips, such as semiconductor chips or chips in which circuits or elements are formed on a substrate, such as a glass substrate, made of a material other than semiconductor materials. Functional devices can include, for example, one or more from among LSIs, memories, imaging devices, light-emitting devices, and (Micro Electro Mechanical Systems) MEMSs. The MEMSs may be, for example, one or more from among pressure sensors, acceleration sensors, gyro sensors, tilt sensors, microphones, and acoustic sensors. According to an example, functional devices may be semiconductor chips including LSIs.

According to still another aspect of the present invention, there is provided a method of producing a wiring board, including preparing a glass substrate having a first surface and a second surface which is to a rear of the first surface; irradiating the glass substrate with a laser beam to form one or more modified portions in the glass substrate; forming a first conductor layer on the first surface, the first conductor layer including a first copper layer facing the first surface, and a hydrofluoric acid resistant metal layer interposed between the first copper layer and the glass substrate to cover the one or more modified portions; etching the second surface using an etching solution containing hydrogen fluoride to form recesses in the second surface and form one or more first through-holes at positions of the one or more modified portions; subjecting portions of the hydrofluoric acid resistant metal layer exposed in the one or more first through-holes to wet etching to form recesses in a surface of the first conductor layer on the glass substrate side; forming an adhesion layer covering side walls of the one or more first through-holes, inner surfaces of the recesses, and the second surface; forming a seed layer on the adhesion layer; and forming a second copper layer on the seed layer, wherein the adhesion layer, the seed layer, and the hydrofluoric acid resistant metal layer are formed so that a sum $T1+T2$ of a thickness $T1$ of the adhesion layer and a thickness $T2$ of the seed layer is greater than or equal to a thickness $T3$ of the hydrofluoric acid resistant metal layer.

According to still another aspect of the present invention, there is provided the method of producing a wiring board according to the above aspect, further including allowing a first support to support the glass substrate so that the second surface faces the first support, prior to irradiating the glass substrate with the laser beam; and removing the first support from the glass substrate after forming the first conductor layer but before forming the one or more first through-holes.

According to still another aspect of the present invention, there is provided the method of producing a wiring board according to any of the above aspects, wherein the wet etching for the hydrofluoric acid resistant metal layer is performed so that one or more second through-holes are formed in the hydrofluoric acid resistant metal layer.

According to still another aspect of the present invention, there is provided the method of producing a wiring board according to any of the above aspects, further including allowing a second support to support a composite including the glass substrate and the first conductor layer so that the first conductor layer faces the second support, after forming the first conductor layer but before forming the one or more first through-holes.

According to the present invention, there is provided a technique with which disconnection is less likely to occur between a wiring layer provided on a glass substrate and TGVs provided in the glass substrate.

[Brief Description of the Drawings]

Fig. 1 is a cross-sectional view illustrating a wiring board according to a first embodiment of the present invention.

Fig. 2 is a cross-sectional view which is a partial enlargement of the wiring board shown in Fig. 1.

Fig. 3 is a cross-sectional view illustrating a process in a method of producing the wiring board shown in Fig. 1.

Fig. 4 is a cross-sectional view illustrating another process in the method of producing the wiring board shown in Fig. 1.

Fig. 5 is a cross-sectional view illustrating still another process in the method of producing the wiring board shown in Fig. 1.

Fig. 6 is a cross-sectional view illustrating still another process in the method of producing the wiring board shown in Fig. 1.

Fig. 7 is a cross-sectional view illustrating still another process in the method of producing the wiring board shown in Fig. 1.

Fig. 8 is a cross-sectional view illustrating still another process in the method of producing the wiring board shown in Fig. 1.

Fig. 9 is a cross-sectional view illustrating still another process in the method of producing the wiring board shown in Fig. 1.

Fig. 10 is a cross-sectional view illustrating still another process in the method of producing the wiring board shown in Fig. 1.

Fig. 11 is a cross-sectional view illustrating still another process in the method of producing the wiring board shown in Fig. 1.

Fig. 12 is a cross-sectional view illustrating an example of a packaged device that can be produced using the wiring board shown in Fig. 1.

Fig. 13 is a cross-sectional view illustrating part of a wiring board according to a comparative example.

Fig. 14 is a cross-sectional view illustrating a through-hole provided in a glass substrate of a wiring board according to a first modification.

Fig. 15 is a cross-sectional view illustrating a through-hole provided in a glass substrate of a wiring board according to a second modification.

Fig. 16 is a perspective view illustrating part of a wiring board according to a third modification.

Fig. 17 is a cross-sectional view illustrating part of a wiring board according to a fourth modification.

Fig. 18 is a cross-sectional view illustrating part of a wiring board according to a fifth modification.

Fig. 19 is a cross-sectional view illustrating part of a wiring board according to a sixth modification.

Fig. 20 is a cross-sectional view illustrating a process in a method of producing a wiring board according to a second embodiment of the present invention.

Fig. 21 is a cross-sectional view illustrating another process in the method of producing the wiring board according to the second embodiment of the present invention.

Fig. 22 is a cross-sectional view illustrating a process in a method of producing a wiring board according to a third embodiment of the present invention.

Fig. 23 is a cross-sectional view illustrating another process the method of producing the wiring board according to the third embodiment of the present invention.

Fig. 24 is a cross-sectional view illustrating a process in a method of producing a wiring board according to a fourth embodiment of the present invention.

Fig. 25 is a cross-sectional view illustrating another process in the method of producing the wiring board according to the fourth embodiment of the present invention.

[Description of the Embodiments]

Referring to the drawings, some embodiments of the present invention will be described. The embodiments described below are more specific implementations of any of the aspects set forth above. The matters described below can be incorporated into the aspects set forth above, either alone or in combination.
The embodiments described below are merely examples of the configurations for specifically implementing the technical ideas of the present invention, and the technical ideas of the present invention should not be construed as being limited to the materials, shapes, structures, and the like of the components described below. Various modifications can be made to the technical ideas of the present invention within the technical scope defined by the claims.

It should be noted that components having equivalent or similar functions are designated with like reference signs in the drawings referenced below to omit repeated explanations. The drawings are only schematic, and the relationship between the dimensions in one direction and the dimensions in another direction, the relationship between the dimensions of one member and the dimensions of other members, and the like, may differ from the actual relationships.

<1> First Embodiment

<1.1> Wiring board

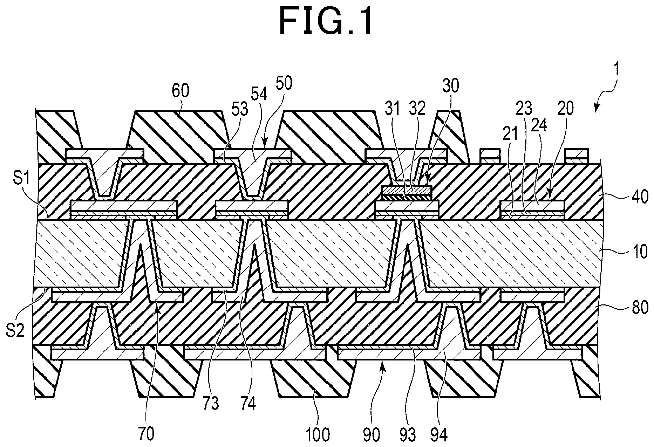

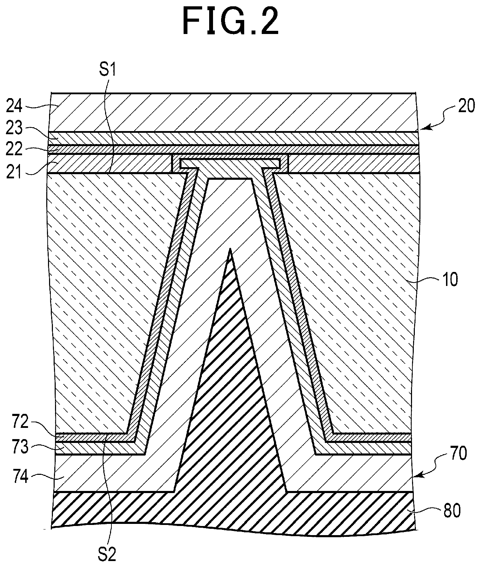

Fig. 1 is a cross-sectional view illustrating a wiring board according to a first embodiment of the present invention. Fig. 2 is a cross-sectional view which is a partial enlargement of the wiring board shown in Fig. 1.

A wiring board 1 shown in Fig. 1 is a glass core wiring board. According to an example, the wiring board 1 is a wiring board used as an interposer, i.e., glass interposer.

The wiring board 1 includes a glass substrate 10, a first conductor layer 20, a dielectric layer 31, an upper electrode 32, an interlayer insulating film 40, a conductor layer 50, an insulating layer 60, a second conductor layer 70, an interlayer insulating film 80, a conductor layer 90, and an insulating layer 100.

The glass substrate 10 has a first surface S1 and a second surface S2 which is the rear of the first surface S1. The first and second surfaces S1 and S2 are parallel to each other.

The glass substrate 10 is provided with one or more first through-holes (a plurality of first through-holes in this example) extending from the first surface S1 to the second surface S2. Each of the first through-holes tapers from the second surface S2 toward the first surface S1.

The first conductor layer 20 comprises conductor patterns provided on the first surface S1. The conductor patterns each include a land, a wiring portion, and a lower electrode of a capacitor 30 described later. The first conductor layer 20 serves as a first wiring layer.

The first conductor layer 20 has a multilayer structure. Specifically, the first conductor layer 20 includes a first copper layer 24 facing the first surface S1, and a hydrofluoric acid resistant metal layer 21 interposed between the first copper layer 24 and the glass substrate 10. As shown in Fig. 2, the first conductor layer 20 further includes an adhesion layer 22 interposed between the hydrofluoric acid resistant metal layer 21 and the first copper layer 24, and a seed layer 23 interposed between the adhesion layer 22 and the first copper layer 24.

The first conductor layer 20 covers the openings of the first through-holes on the first surface S1 side. The surface of the first conductor layer 20 on the glass substrate 10 side has recesses at positions of the first through-holes. In this example, the hydrofluoric acid resistant metal layer 21 is provided with second through-holes at positions of the first through-holes. The second through-holes form the recesses mentioned above in the surface of the first conductor layer 20 on the glass substrate 10 side.

The contour of the opening of each of the recesses provided in the surface of the first conductor layer 20 (hereinafter may also be referred to as first opening) is wider than and surrounds the opening of the corresponding one of the first through-holes on the first surface S1 side (hereinafter may also be referred to as second opening). That is, the contour of the orthogonal projection of each first opening onto a plane perpendicular to the thickness direction of the wiring board 1 is wider than and surrounds the orthogonal projection of the corresponding second opening onto this plane. The distance from the contour of the orthogonal projection of the first opening onto the plane to the orthogonal projection of the corresponding second opening onto the plane, i.e., the width of an undercut produced by side etching described later, is in the range of 1 $\mu$m to 10 $\mu$m according to an example, and in the range of 0.1 $\mu$m to 5 $\mu$m according to another example.

The hydrofluoric acid resistant metal layer 21 is made of a metal material having superior resistance to etching using hydrofluoric acid, compared to the glass substrate 10 . For example, the hydrofluoric acid resistant metal layer 21 may be made of a material selected from the group consisting of chromium, nickel, and nickel-chromium alloys. The hydrofluoric acid resistant metal layer 21 has a thickness T3 which is preferred to be in the range of 10 nm to 500 nm, and is more preferred to be in the range of 0.02 $\mu$m to 0.08 $\mu$m.

The adhesion layer 22 and the seed layer 23 are laminated in this order on the hydrofluoric acid resistant metal layer 21. The adhesion layer 22 and the seed layer 23 can be made of the materials exemplified respectively for an adhesion layer 72 and a seed layer 73 described later. The adhesion layer 72 and the seed layer 73 are provided when the first copper layer 24 is formed by electrolytic plating. The adhesion layer 72 may be omitted. Furthermore, when the first copper layer 24 is formed using other methods such as electroless plating or sputtering, both the adhesion layer 22 and the seed layer 23 may be omitted.

The dielectric layer 31 and the upper electrode 32 are laminated in this order on part of the first conductor layer 20. The portion of the first conductor layer 20 facing the upper electrode 32 serves as a lower electrode. The upper electrode 32, the dielectric layer 31, and the lower electrode form a capacitor 30, specifically a MIM capacitor.

In the example shown in Fig. 1, the lower electrode covers the opening of the corresponding first through-hole on the first surface S1 side. The lower electrode may be spaced apart from the first through-hole, but if it is arranged to cover the opening of the corresponding first through-hole on the first surface S1 side, the electrical resistance caused by the wiring can be reduced and the wiring length can be shortened.

Although the capacitor 30 is disposed so as to face the first surface S1 in this example, the capacitor may be disposed on the second surface S2 side. Alternatively, while the capacitor 30 is disposed so as to face the first surface S1, another capacitor may further be disposed on the second surface S2 side. The capacitor 30 may be omitted.

The interlayer insulating film 40 covers the first surface S1 and has embedded therein the first conductor layer 20, the dielectric layer 31, and the upper electrode 32. The interlayer insulating film 40 has through-holes at positions of the lands included in the first conductor layer 20 and at the position of the upper electrode 32. According to an example, the interlayer insulating film 40 comprises an insulating resin layer.

The conductor layer 50 comprises conductor patterns provided on the interlayer insulating film 40. The conductor patterns each include a pad provided on the major surface of the interlayer insulating film 40, and a via covering the side walls of the corresponding through-hole provided in the interlayer insulating film 40. The pad serves as an external connection terminal. Each via connects the corresponding land included in the first conductor layer 20 or the upper electrode 32 to the corresponding pad.

The conductor layer 50 includes a seed layer 53 and a copper layer 54. The seed layer 53 and the copper layer 54 are laminated in this order on the interlayer insulating film 40. The conductor layer 50 can further include an adhesion layer between the interlayer insulating film 40 and the seed layer 53. The adhesion layer included in the conductor layer 50 and the seed layer 53 can be made of the materials exemplified respectively for the adhesion layer 72 and the seed layer 73 described later. The seed layer 53 may be omitted.

The insulating layer 60 at least partially covers the interlayer insulating film 40 and has embedded therein the conductor layer 50. The insulating layer 60 is provided with through-holes at positions of the pads included in the conductor layer 50. For example, the insulating layer 60 may be made of a solder resist.

The second conductor layer 70 comprises conductor patterns each including a portion covering the second surface S2 of the glass substrate 10, a portion covering the side walls of the first through-hole provided in the glass substrate 10, and a portion covering the inner surface of the recess provided in the first conductor layer 20. The conductor patterns each include a land, a wiring portion, and a via. The portions of the second conductor layer 70 covering the second surface S2 are portions of a second wiring layer respectively including lands and wiring portions. The vias each include a portion of the second conductor layer 70 covering the side walls of the corresponding one of the first through-holes provided in the glass substrate 10, and a portion thereof covering the inner surface of the corresponding one of the recesses provided in the first conductor layer 20.

The second conductor layer 70 has a multilayer structure. Specifically, as shown in Fig. 2, the second conductor layer 70 includes an adhesion layer 72, a seed layer 73, and a second copper layer 74. The adhesion layer 72, seed layer 73, and second copper layer 74 are laminated in this order on the glass substrate 10.

The adhesion layer 72 covers the side walls of the first through-holes provided in the glass substrate 10, the inner surfaces of the recesses provided in the first conductor layer 20, and the regions of the second surface S2 surrounding the openings of the first through-holes on the second surface S2 side. The adhesion layer 72 is conformal to these surfaces.

The adhesion layer 72 enhances adhesion of the seed layer 73 to the glass substrate 10. The adhesion layer 72 is preferred to be made of one or more materials selected from the group consisting of titanium, chromium, and nickel, or oxides thereof, and are more preferred to be made of titanium or a titanium oxide. The adhesion layer 72 has a thickness T1 which is preferred to be in the range of 10 nm to 0.5 $\mu$m, and is more preferred to be in the range of 20 nm to 0.08 $\mu$m. The thickness T1 of the adhesion layer 72 is a thickness of the adhesion layer 72 at a portion on the second surface S2.

In order to increase a sum T1+T2 of the thickness T1 of the adhesion layer 72 and a thickness T2 of the seed layer 73, it is advantageous to increase the thickness T1. However, if the thickness T1 is too large, the connection resistance between the first and second conductor layers 20 and 70 increases.

The seed layer 73 is provided on the adhesion layer 72. The seed layer 73 is conformal to the adhesion layer 72. The seed layer 73 functions as a power supply layer for electrolytic plating. For example, the seed layer 73 may be made of copper. The thickness T2 of the seed layer 73 is preferred to be in the range of 100 nm to 0.5 $\mu$m, and is more preferred to be in the range of 200 nm to 0.4 $\mu$m. The thickness T2 of the seed layer 73 is a thickness of the seed layer 73 at a portion on the second surface S2.

Considering the function as a power supply layer, the seed layer 73 is preferred to be thick. However, if the thickness T2 is increased, in the case of forming the second conductor layer 70 using a semi-additive method, the surface regions of the second copper layer 74 may be removed during removal of the unnecessary portions of the seed layer 73, etc., which are formed as continuous films, by full-surface etching. Therefore, if the thickness T2 is increased, the shape accuracy or dimensional accuracy of the wiring included in the second conductor layer 70 may be reduced.

The second copper layer 74 is provided on the seed layer 73. The second copper layer 74 is conformal to the seed layer 73. For example, the second copper layer 74 may have a thickness in the range of 2 $\mu$m to 10 $\mu$m.

The sum T1+T2 of the thickness T1 of the adhesion layer 72 and the thickness T2 of the seed layer 73 is equal to or greater than the thickness T3 of the hydrofluoric acid resistant metal layer 21. That is, the thicknesses T1 to T3 satisfy the relationship shown in the following Inequality (1).

$$T3 \leq T1+T2 \qquad \ldots (1)$$

The sum T1+T2 is preferred to be greater than the thickness T3, more preferred to be twice or more the thickness T3, and even more preferred to be six times or more the thickness T3. The thicknesses T2 and T3 may satisfy the relationship shown in the following Inequality (1).

$$T3 \leq T1 \qquad \ldots (2)$$

As described later, if the thicknesses T1 to T3 satisfy the above relationship, the seed layer 73 is less likely to produce a discontinuity due to an undercut between the bottom surface of each recess provided in the first conductor layer 20 and the side walls of the corresponding first through-hole. Therefore, in the electrolytic plating for forming the second copper layer 74, the deposition of copper in the recesses provided in the first conductor layer 20 is less likely to be insufficient.

The sum T1+T2 is preferred to be 20 times or less than the thickness T3, and more preferred to be 8 times or less than the thickness T3. In the case of forming the second conductor layer 70 using a semi-additive method, the unnecessary portions of the adhesion layer 72, the seed layer 73, etc., which are formed as continuous films, are removed by full-surface etching. If the sum T1+T2 is increased, the time required for removing these unnecessary portions will become longer.

The thickness T2 is preferred to be greater than or equal to a sum T1+T3 of the thicknesses T1 and T3. That is, the thicknesses T1 to T3 are preferred to satisfy the relationship shown in the following Inequality (3).

$$T1+T3 \leq T2 \qquad \ldots (3)$$

If the thicknesses T1 to T3 satisfy the above relationship, the seed layer 73 is thicker than the hydrofluoric acid resistant metal layer 21 and the adhesion layer 72. If such a configuration is adopted, the seed layer 73 can exhibit particularly excellent performance as a power supply layer during electrolytic plating for forming the second copper layer 74.

The interlayer insulating film 80 covers the second surface S2 and has embedded therein the second conductor layer 70. The interlayer insulating film 80 has through-holes at positions of the lands included in the second conductor layer 70. According to an example, the interlayer insulating film 40 comprises an insulating resin layer.

The conductor layer 90 comprises conductor patterns provided on the interlayer insulating film 80. The conductor patterns each include a pad provided on the major surface of the interlayer insulating film 80, and a via covering the side walls of the corresponding through-hole provided in the interlayer insulating film 80. The pad serves as an external connection terminal. Each via connects the corresponding land included in the second conductor layer 70 to the corresponding one of the pads.

The conductor layer 90 includes a seed layer 93 and a copper layer 94. The seed layer 93 and the copper layer 94 are laminated in this order on the interlayer insulating film 80. The conductor layer 90 can further include an adhesion layer between the interlayer insulating film 80 and the seed layer 93. The adhesion layer included in the conductor layer 90 and the seed layer 93 can be made of the materials exemplified respectively for the adhesion layer 72 and the seed layer 73. The seed layer 93 may be omitted.

The insulating layer 100 at least partially covers the interlayer insulating film 80 and has embedded therein the conductor layer 90. The insulating layer 100 is provided with through-holes at positions of the pads included in the conductor layer 90. For example, the insulating layer 100 may be made of a solder resist.

<1.2> Method of producing wiring board

For example, the wiring board 1 can be produced using the following method.

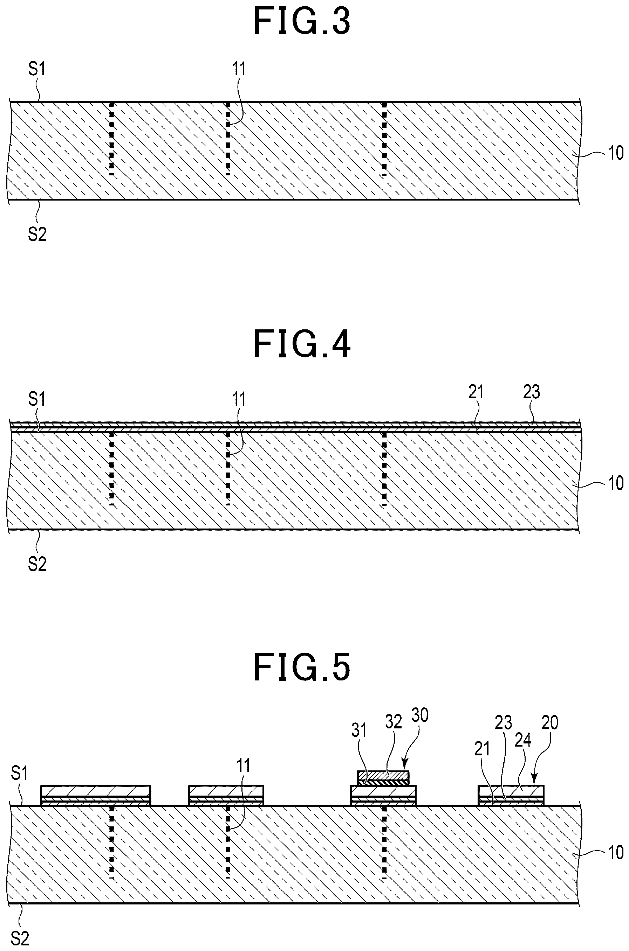

Figs. 3 to 11 are cross-sectional views illustrating processes in a method of producing the wiring board shown in Fig. 1.

<1.2.1> First process

In this method, first, a glass substrate 10 having a first surface S1 and a second surface S2 which is the rear of the first surface S1 is prepared. For example, contaminants are removed from the surface of a non-alkali glass plate having a

thickness of 500 $\mu$m by ultrasonic cleaning or the like to obtain a glass substrate 10. The glass substrate 10 at this stage is thicker than the glass substrate 10 included in the wiring board 1. The glass substrate 10 at this stage is a large-sized glass substrate having a larger dimension in the direction perpendicular to the thickness direction, compared to the glass substrate 10 included in a packaged device described later.

<1.2.2> Second process

Next, the glass substrate 10 is irradiated with a laser beam from the first surface S1 to the second surface S2 to form one or more modified portions 11 in the glass substrate 10 as shown in Fig. 3. For example, the modified portions 11 are portions that are heated by laser irradiation and thus have a difference in crystallinity or the like from the portions not irradiated with the laser beam. The modified portions 11 are formed at positions corresponding to the first through-holes. The modified portions 11 extend from the first surface S1 to the second surface S2 in the thickness direction, for example, of the glass substrate 10. It is preferred that the laser intensity is adjusted so that the modified portions 11 extending from the first surface S1 do not reach the second surface S2.

The laser beam used in this example has a wavelength of 535 nm or less. The wavelength of the laser beam is preferred to be 355 nm or more and 535 nm or less. If the wavelength of the laser beam is less than 355 nm, sufficient laser output is less likely to be attained, and therefore it may be difficult to attain laser modification in a stable manner. However, if the wavelength of the laser beam is greater than 535 nm, the irradiation spots may become larger, and it may be difficult to form laser modification in smaller areas. Furthermore, due to the influence of heat, microcracks may occur, and the glass substrate 10 may become fragile.

In the case of using a pulsed laser, the laser pulse width is preferred to be in the range of picoseconds to femtoseconds. If the laser pulse width is longer than nanoseconds, it may become difficult to control the amount of energy per pulse, microcracks may occur, and the glass substrate 10 may become fragile.

The energy value of the laser pulses is preferred to be selected according to the type of laser modification to be caused, and is preferred to be in the range of 5 $\mu$J or more and 150 $\mu$J or less. By increasing the laser pulse energy, the length of the modified portions 11 can be increased in proportion to the increase in the laser pulse energy.

<1.2.3> Third process

Next, a first conductor layer 20 including a first copper layer 24 facing the first surface S1, and a hydrofluoric acid resistant metal layer 21 interposed between the first copper layer 24 and the glass substrate 10 is formed on the first surface S1 to cover the modified portions 11.

For example, as shown in Fig. 4, first, a hydrofluoric acid resistant metal layer 21 and a seed layer 23 may be formed in this order on the first surface S1. The hydrofluoric acid resistant metal layer 21 and the seed layer 23 in this example are formed as continuous films. For example, the hydrofluoric acid resistant metal layer 21 may be formed by sputtering. For example, the seed layer 23 may be formed by sputtering or electroless plating. Prior to forming the seed layer 23, an adhesion layer 22 shown in Fig. 2 may be formed on the hydrofluoric acid resistant metal layer 21. For example, the adhesion layer 22 may be formed as a continuous film by sputtering or electroless plating. Formation of the adhesion layer 22 improves adhesion between the hydrofluoric acid resistant metal layer 21 and the seed layer 23.

Next, a mask pattern formed of an insulator is formed on the seed layer 23 so as to have openings at positions corresponding to parts of the first copper layer 24. For example, the mask pattern may be formed by providing a photoresist layer on the seed layer 23 and performing pattern exposure and development of the photoresist layer. According to an example, RD1225 that is a dry photoresist manufactured by Showa Denko Materials Co., Ltd. is laminated on the seed layer 23 and the dry photoresist is pattern-exposed and developed sequentially to obtain a mask pattern made of a resin.

Subsequently, electrolytic copper plating is performed using the seed layer 23 as a power supply layer. Thus, copper is deposited on the seed layer 23 at positions of the openings of the mask pattern to obtain a first copper layer 24 shown in Fig. 5.

After that, the mask pattern is removed. For example, the dry film resist may be dissolved and peeled off. Next, the entire surface of the composite including the first copper layer 24 and the glass substrate 10 is etched on the first copper layer 24 side until the exposed portions of the seed layer 23 are removed. If an adhesion layer 22 is provided between the seed layer 23 and the hydrofluoric acid resistant metal layer 21, the entire surface of the composite on the first copper layer 24 side is further etched until the portions of the adhesion layer 22 that have been exposed by removing the exposed portions of the seed layer 23 are also removed.

In this way, the first conductor layer 20 shown in Fig. 5 is obtained. As described above, the first conductor layer 20 includes lands, wiring portions, and lower electrodes.

<1.2.4> Fourth process

Next, a dielectric layer 31 and an upper electrode 32 are formed in this order on the lower electrode included in the first conductor layer 20 to obtain a capacitor 30 shown in Fig. 5. For example, the upper electrode 32 can be formed using a method similar to the method described for the seed layer 23 and the first copper layer 24 included in the first conductor layer 20. Such an upper electrode 32 has a multilayer structure including a seed layer and a copper layer.

<1.2.5> Fifth process

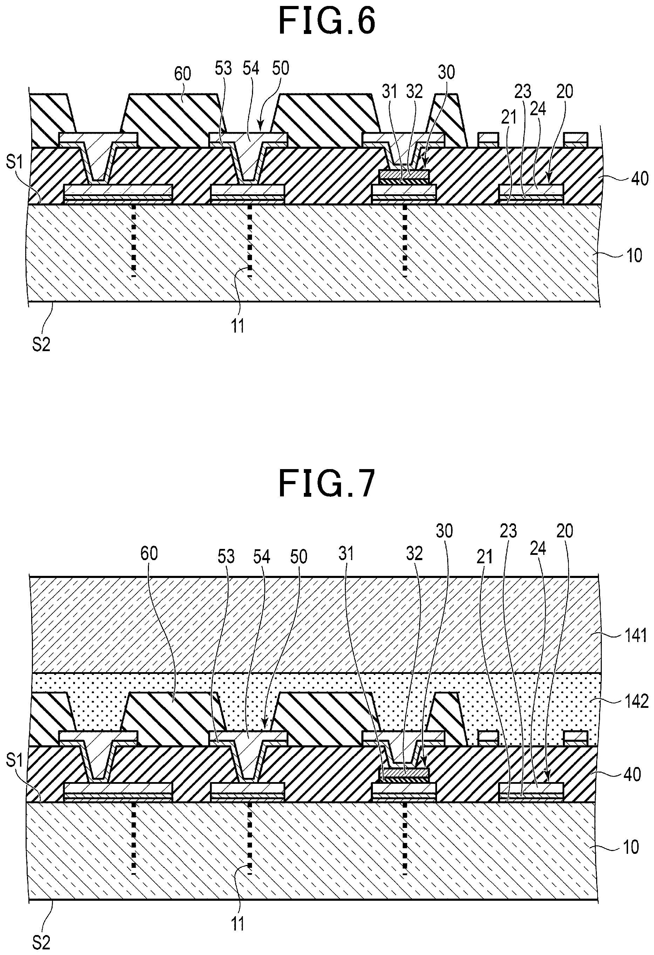

Next, an insulating resin layer is provided to the surface of the composite including the capacitor 30 and the glass substrate 10 on the capacitor 30 side. According to an example, ABF-GXT31 (thickness: 32.5 μm) that is an insulating resin film manufactured by Ajinomoto Fine-Techno Co., Inc. is laminated on the surface mentioned above and pre-cured. Next, blind vias are formed in the insulating resin layer by laser processing. After that, residues produced due to the laser processing are removed by performing desmearing. In this way, the interlayer insulating film 40 shown in Fig. 6 is obtained.

Next, a seed layer 53 is formed by sputtering or electroless plating. In this example, the seed layer 53 is formed to cover the upper surface of the interlayer insulating film 40, the side walls of the through-holes provided to the film, and portions of the first conductor layer 20 and the upper electrode 32 exposed at positions of the through-holes.

Next, a mask pattern formed of an insulator is formed on the seed layer 53 so as to have openings at positions corresponding to parts of the copper layer 54. For example, the mask pattern may be formed by providing a photoresist layer on the seed layer 53 and performing pattern exposure and development of the photoresist layer. According to an example, RD1225 that is a dry film resist manufactured by Showa Denko Materials Co., Ltd. is laminated on the seed layer 53 and the dry film resist is pattern-exposed and developed sequentially to obtain a mask pattern made of a resin.

Subsequently, electrolytic plating is performed using the seed layer 53 as a power supply layer. Thus, copper is deposited on the seed layer 53 at positions of the openings of the mask pattern to obtain a copper layer 54 shown in Fig. 6.

After that, the mask pattern is removed. For example, the dry film resist may be dissolved and peeled off. Next, the entire surface of the composite including the copper layer 54 and the glass substrate 10 is etched on the copper layer 54 side until the exposed portions of the seed layer 53 are removed. In this way, a conductor layer 50 is obtained.

Next, an insulating layer 60 shown in Fig. 6 is provided on the interlayer insulating film 40. For example, a solder resist may be provided on the interlayer insulating film 40, followed by patterning using a photolithography method or the like. In this way, the structure shown in Fig. 6 is obtained.

<1.2.6> Sixth process

Next, as shown in Fig. 7, the composite including the glass substrate 10 and the insulating layer 60 is supported by a second support 141 such that the insulating layer 60 faces the second support 141. The second support 141 is bonded to the composite via an adhesive 142 for temporary bonding. The second support 141 contributes to reducing breakage of the glass substrate 10 when it is thinned in the next process, and facilitating handling of the composite including the glass substrate 10.

For example, REVALPHA (trademark) manufactured by Nitto Denko Corporation may be used as the adhesive 142. For example, a thin glass carrier may be used as the second support 141. The second support 141 does not have to be made of glass but may be made of a metal or resin.

The second support 141 is preferred to have a thickness in the range of 0.7 mm or more and 10 mm or less from the perspective of transferability of the glass substrate 10 after being thinned. The thickness of the second support 141 may be appropriately determined according to the thickness of the glass substrate 10.

<1.2.7> Seventh process

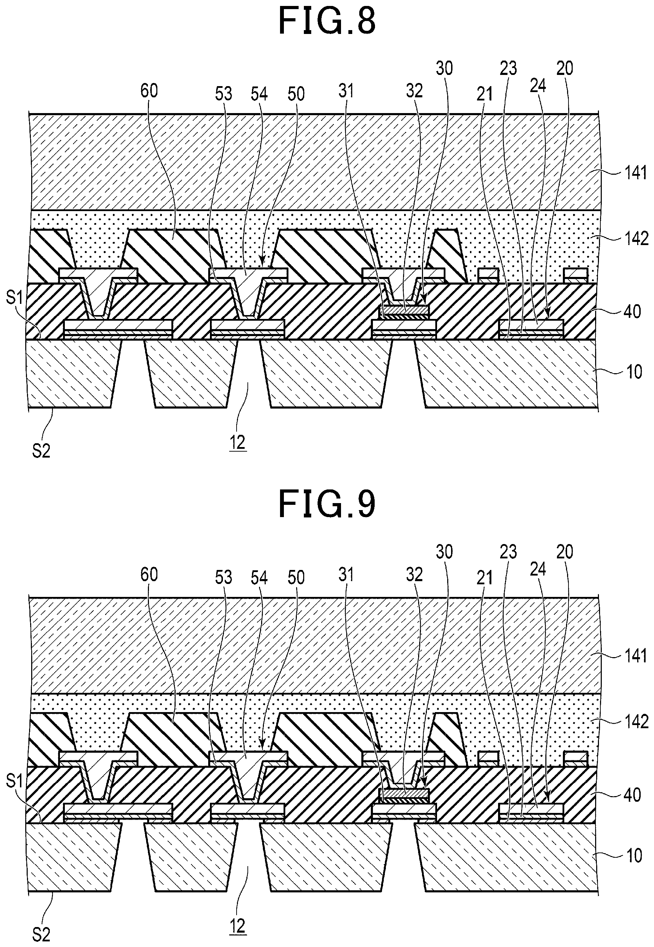

Next, the second surface S2 of the composite supported by the second support 141 is etched with an etching solution containing hydrogen fluoride to form recesses in the second surface S2 and form first through-holes 12 at positions of the modified portions 11, as shown in Fig. 8. As a result of etching the second surface S2, the glass substrate 10 is thinned and the modified portions 11 are exposed. The modified portions 11 of the glass substrate 10 have a higher etching rate compared to other portions. Accordingly, the etching can simultaneously achieve thinning of the glass substrate 10 and formation of the first through-holes 12.

In the etching, the hydrofluoric acid resistant metal layer 21 functions as an etching stopper film. In Fig. 8, the first through-holes 12 obtained by the etching each have a frustoconical shape with a radius (or cross section) on the second surface S2 side larger than a radius (or cross section) on the first surface S1 side.

The amount of etching of the glass substrate 10 may be appropriately determined according to the thickness of the wiring board 1. For example, if the thickness of the glass substrate 10 before etching is 400 μm, the amount of etching is preferred to be in the range of 100 $\mu$m or more and 350 $\mu$m or less. The thickness of the glass substrate 10 after thinning is preferred to be in the range of 50 $\mu$m or more and 300 $\mu$m or less.

For example, the etching solution containing hydrogen fluoride may be an aqueous solution of hydrogen fluoride. The etching solution can further contain one or more inorganic acids selected from the group consisting of nitric acid, hydrochloric acid, and sulfuric acid.

For example, the hydrogen fluoride concentration of the etching solution may be in the range of 1.0 mass% or more and 6.0 mass% or less, or is more preferred to be in the range of 2.0 mass% or more and 5.0 mass% or less. For example, the inorganic acid concentration is preferred to be in the range of 1.0 mass% or more and 20.0 mass% or less, or is more preferred to be in the range of 3.0 mass% or more and 16.0 mass% or less. It is desirable to perform etching at an etching rate of 1.0 $\mu$m/min or less using an etching solution in which the concentrations of the components are set within the above ranges. During the etching, it is desirable that the etching solution has a temperature in the range of 10°C or more and 40°C or less.

<1.2.8> Eighth process

Next, portions of the hydrofluoric acid resistant metal layer 21 exposed in the individual first through-holes 12 are subjected to wet etching to form recesses, as shown in Fig. 9, in the surface of the first conductor layer 20 on the glass substrate 10 side. In this example, the wet etching of the hydrofluoric acid resistant metal layer 21 is performed so that second through-holes are formed in the hydrofluoric acid resistant metal layer 21.

Any etching solution may be used for this wet etching as long as the exposed portions of the hydrofluoric acid resistant metal layer 21 can be removed. As the etching solution, a chromium etching solution is favorably used.

According to an example, an alkaline chromium etching solution manufactured by Nihon Kagaku Sangyo Co., Ltd. containing potassium ferricyanide and potassium hydroxide is used as the above etching solution. Using this etching solution, wet etching is performed at a temperature of 40°C for 1.5 minutes. According to such wet etching, only the exposed portions of the hydrofluoric acid resistant metal layer 21 can be removed without damaging other members, e.g., the glass substrate 10, first copper layer 24, and interlayer insulating film 40, than the hydrofluoric acid resistant metal layer 21.

As described above, the first through-holes 12 each have a frustoconical shape with a radius (or cross section) on the second surface S2 side larger than a radius (or cross section) on the first surface S1 side. Such a shape promotes circulation of the etching solution between the inside and outside of the first through-holes 12, enabling efficient etching.

Prior to the wet etching, for example, it is preferred to perform plasma treatment using $CF_4$ gas, oxygen gas, argon gas, or hydrogen gas, or perform ultrasonic cleaning to improve wettability of the hydrofluoric acid resistant metal layer 21 to the etching solution at the exposed portions. It is more preferred to perform both the plasma treatment and ultrasonic cleaning. In this case, the effect of improving wettability is further enhanced.

<1.2.9> Ninth process

After that, the adhesion layer 72 shown in Fig. 2 is formed. In this example, the adhesion layer 72 is formed as a continuous film covering the side walls of the first through-holes 12, the inner surfaces of the recesses formed in the first conductor layer 20, and the second surface S2. For example, the adhesion layer 72 may be formed as a continuous film by sputtering or electroless plating. In order to deposit a metal into the undercuts described later, the adhesion layer 72 is preferred to be formed by electroless plating.

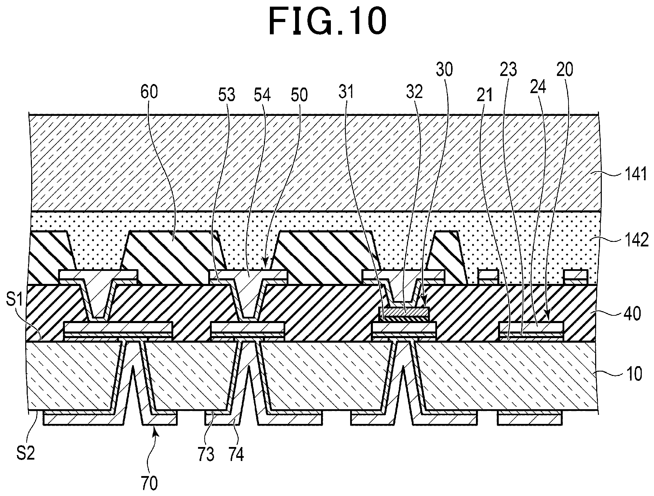

Next, a seed layer 73 shown in Fig. 10 is formed on the adhesion layer 72. For example, the seed layer 73 may be formed as a continuous film by sputtering or electroless plating. In order to deposit a metal into the undercuts, the seed layer 73 is preferred to be formed by electroless plating.

The adhesion layer 73 and the seed layer 72 are formed such that the thickness T1 of the adhesion layer 72, the thickness T2 of the seed layer 73, and the thickness T3 of the hydrofluoric acid resistant metal layer satisfy the relationships described above.

<1.2.10> Tenth process

Next, as shown in Fig. 10, a second copper layer 74 is formed on the seed layer 73.

For example, first, a mask pattern formed of an insulator is formed on the seed layer 73 so as to have openings at positions corresponding to parts of the second copper layer 74. For example, the mask pattern may be formed by providing a photoresist layer on the seed layer 73 and performing pattern exposure and development of the photoresist layer. According to an example, RD1225 that is a dry photoresist manufactured by Showa Denko Materials Co., Ltd. is laminated on the seed layer 73 and the dry photoresist is pattern-exposed and developed sequentially to obtain a mask pattern made of a resin.

Subsequently, electrolytic copper plating is performed using the seed layer 73 as a power supply layer. Thus, copper is deposited on the seed layer 73 at positions of the openings of the mask pattern to obtain the second copper layer 74 shown in Fig. 10.

After that, the mask pattern is removed. For example, the dry film resist may be dissolved and peeled off. Next, the entire surface of the composite including the second copper layer 74 and the glass substrate 10 is etched on the second copper layer 74 side until the exposed portions of the seed layer 73 are removed. Subsequently, the entire surface of the composite on the second copper layer 74 side is further etched until the portions of the adhesion layer 72 that have been exposed by removing the exposed portions of the seed layer 73 are removed.

In this way, the second conductor layer 70 shown in Fig. 10 is obtained. As described above, the second conductor layer 70 includes lands and wiring portions.

<1.2.11> Eleventh process

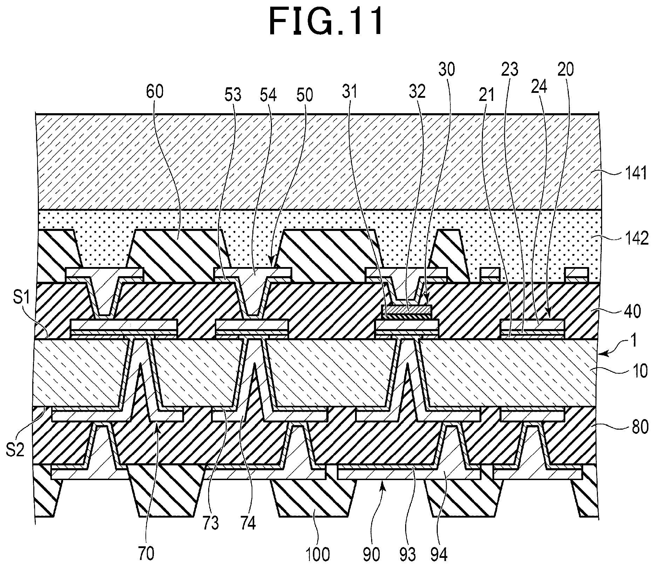

Next, the surface of the composite including the second conductor layer 70 and the glass substrate 10 on the second conductor layer 70 side is subjected to a treatment as in the fifth process to provide the interlayer insulating film 80, the conductor layer 90, and the insulating layer 100 shown in Fig. 11.

<1.2.12> Twelfth process

After that, the second support 141 and the adhesive 142 are removed from the composite including the glass substrate 10, the first conductor layer 20, the second conductor layer 70, etc. In this way, the wiring board 1 shown in Fig. 1 is obtained.

<1.3> Packaged device

The wiring board 1 described above can be used for producing packaged devices.

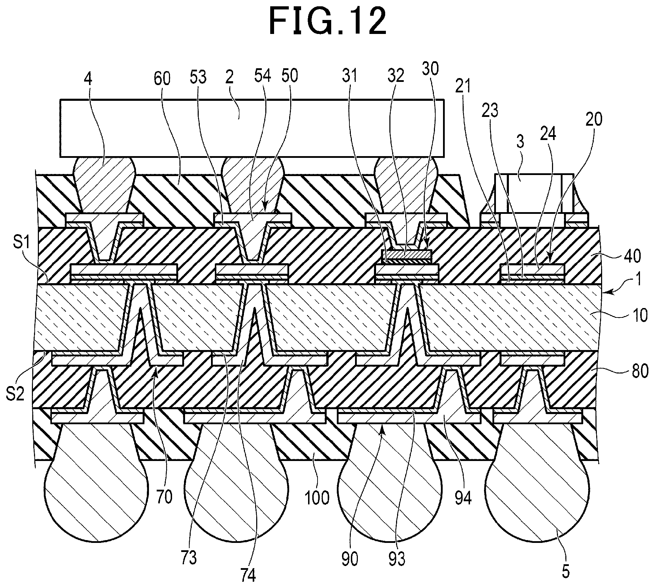

Fig. 12 is a cross-sectional view illustrating an example of a packaged device that can be produced using the wiring board shown in Fig. 1. For example, the packaged device shown in Fig. 12 may be a high frequency device including an LC filter. The packaged device shown in Fig. 12 includes the wiring board 1, a functional device 2, a chip component 3, and bonding conductors 4 and 5.

The wiring board 1 is obtained by dividing the wiring board described referring to Fig. 1, etc. The wiring board 1 may further include at least either of the bonding conductors 4 and 5.

The bonding conductors 4 and 5 are solder balls in this example. The bonding conductors 4 are provided on the respective pads included in the conductor layer 50. The bonding conductors 4 bond the functional device 2 to the wiring board 1. The bonding conductors 5 are provided on the respective pads included in the conductor layer 90. The bonding conductors 5 can bond the packaged device to another wiring board, e.g., mother board.

As described above, the functional device 2 is a device activated with a supply of electrical power and/or electrical signals, a device outputting electrical power and/or electrical signals due to external stimulation, or a device activated with a supply of electrical power and/or electrical signals and outputting electrical power and/or electrical signals due to external stimulation. The functional device 2 may be, for example, in the form of a chip, such as a semiconductor chip or a chip in which circuits or elements are formed on a substrate, such as a glass substrate, made of a material other than semiconductor materials. For example, the functional device 2 can include one or more from among LSIs, memories, imaging elements, light-emitting elements, and MEMSs. The MEMSs may be, for example, one or more from among pressure sensors, acceleration sensors, gyro sensors, tilt sensors, microphones, and acoustic sensors. According to an example, functional devices may be semiconductor chips including LSIs.

The functional device 2 is mounted on the wiring board 1. In this example, the functional device 2 is mounted on the wiring board 1 using flip chip bonding. The functional device 2 may be mounted on the wiring board 1 using other surface mounting techniques. The packaged device may include two or more functional devices 2.

The chip component 3 is a passive component on which chip resistors, chip capacitors, chip inductors, etc. can be surface-mounted. The chip component 3 is mounted on the wiring board 1. In this example, the chip component 3 is mounted on the wiring board 1 using die bonding and wire bonding. The chip component 3 may be mounted on the wiring board 1 using other surface mounting techniques. The packaged device may include two or more chip components 3. The chip component 3 may be omitted. In this example, the chip component 3 is a chip inductor and constitutes an LC filter together with the capacitor 30.

<1.4> Effects

For example, the technique described above provides the following effects.

<1.4.1> Handleability

According to the production method described above, the glass substrate 10 is less likely to suffer damage, and can achieve good handleability. This will be described below.

Forming through-holes in glass substrates may deteriorate the physical strength of the glass substrates. Also, glass substrates with a small thickness, e.g., glass substrates with a thickness of 300 $\mu$m or less, easily undergo cracking during transfer for forming conductors such as circuits, and thus are difficult to handle.

In the method described above, the glass substrate 10 is relatively thick during formation of the first conductor layer 20 and the like on the first surface S1 and thus is less likely to be broken. In addition, the composite including the glass substrate 10 and the first conductor 20 has high strength even after the thinning of the glass substrate 10 and formation of the first through-holes 12. Therefore, the glass substrate 10 is less likely to be damaged in the processes that follow. Furthermore, the second support 141 contributes to further reduce breakage of the glass substrate 10. Also, since the strength of the composite is enhanced by forming the second conductor layer 70, etc. before removal of the second support 141, the glass substrate 10 is less likely to be damaged even after removal of the second support 141 from the composite.

Thus, according to the production method described above, the glass substrate 10 is less likely to be damaged, and can be easily handled.

<1.4.2> Productivity

According to the production method described above, high productivity can be achieved as described below.

In the TSV technique, methods such as the Bosch process, in which dry etching is used, have been established as methods of forming through-holes in silicon substrates. However, forming through-holes in a glass substrate by dry etching takes a long time and may not be practical.

In the production method described above, wet etching which is used for thinning the glass substrate 10 is also used for forming the first through-holes 12. The first through-holes 12 are formed at positions of the modified portions 11 produced by laser irradiation. The modified portions 11 of the glass substrate 10 have a higher etching rate compared to other portions. Accordingly, according to the production method described above, high productivity can be achieved.

<1.4.3> Electrical characteristics

The wiring board 1 obtained through the method described above has good electrical characteristics at connecting portions between the wiring layer provided on the glass substrate 10 and the TGVs provided in the glass substrate.

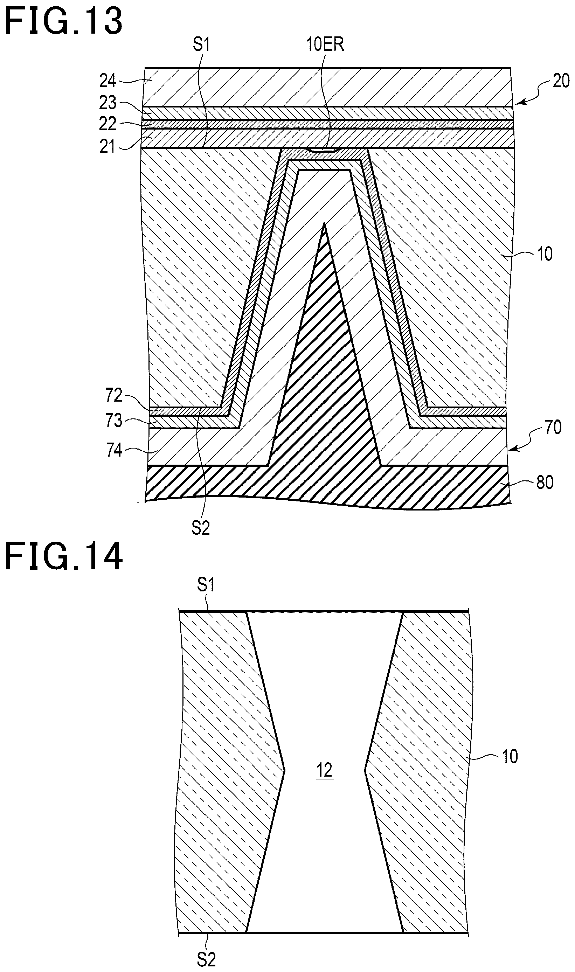

Fig. 13 is a cross-sectional view illustrating part of a wiring board according to a comparative example.

The method described referring to Figs. 1 to 11 has the seventh process in which etching is performed using an etching solution containing hydrogen fluoride to form the first through-holes 12 in the glass substrate 10. As shown in Fig. 13, the structure immediately after the etching is likely to have etching residues 10ER of the glass substrate 10 (also referred to as glass residues) in the first through-holes 12, i.e., on the hydrofluoric acid resistant metal layer 21. As shown in Fig. 13, if the second conductor layer 70 is formed without removing the etching residues 10ER, the etching residues 10ER may interfere with the electrical connection between the first and second conductor layers 20 and 70.

In the eighth process, following the seventh process of the method described above, portions of the hydrofluoric acid resistant metal layer 21 exposed at positions of the first through-holes 12 are removed by wet etching. Wet etching, which is isotropic etching, can also remove portions of the hydrofluoric acid resistant metal layer 21 directly below the etching residues 10ER by side etching. Therefore, this etching can also remove the etching residues 10ER. In general, materials used for the hydrofluoric acid resistant metal layer 21 have electrical resistance greater than that of copper, etc. Therefore, removing portions of the hydrofluoric acid resistant metal layer 21 exposed at positions of the first through-holes 12 can reduce connection resistance between the first and second conductor layers 20 and 70.

In the method described above, portions of the hydrofluoric acid resistant metal layer 21 exposed at positions of the first through-holes 12 are removed by wet etching which is isotropic etching. Therefore, as shown in Fig. 2, portions of the hydrofluoric acid resistant metal layer 21 removed include not only those portions which correspond to the openings of the first through-holes 12 on the first surface S1 side, but also those portions which surround these openings that are removed by side etching. That is, undercuts are produced in the hydrofluoric acid resistant metal layer 21. The undercuts can increase the contact area between the first and second conductor layers 20 and 70.

Accordingly, the wiring board 1 obtained through the method described above has good electrical characteristics at connecting portions between the wiring layer provided on the glass substrate 10 and the TGVs provided in the glass substrate.

<1.4.4> Connection reliability

The wiring board 1 obtained through the method described above has high connection reliability between the wiring layer provided on the glass substrate 10 and the TGVs provided in the glass substrate.

The etching residues 10ER shown Fig. 13 deteriorate adhesion between the hydrofluoric acid resistant metal layer 21 and second conductor layer 70, and therefore deteriorate connection reliability between the first and second conductor layers 20 and 70. In the eighth process, following the seventh process of the method described above, portions of the hydrofluoric acid resistant metal layer 21 exposed at positions of the first through-holes 12 are removed by wet etching. By removing portions of the hydrofluoric acid resistant metal layer 21 exposed at positions of the first through-holes 12, the etching residues 10ER located on these portions are also removed.

In the wiring board 1, stress is concentrated at the connecting portions between the first and second conductor layers 20 and 70. Therefore, connection reliability is greatly affected by disconnection occurring at these connecting portions.

In the wiring board 1, the hydrofluoric acid resistant metal layer 21 includes undercuts and the second conductor layer 70 at least has partially embedded therein the undercuts. If stresses are applied to portions of the composite layer composed of the seed layer 73 and the second copper layer 74 located in the first through-holes 12 in the direction of separating these portions from the first conductor layer 20, the portions of the second conductor layer 70 having embedded therein the undercuts can make it difficult for the portions located in the first through-holes 12 to move.

Accordingly, the wiring board 1 obtained through the method described above has high connection reliability between the wiring layer provided on the glass substrate 10 and the TGVs provided in the glass substrate.

<1.4.5> Yield

Furthermore, according to the method described above, disconnection can be made less likely to occur between the wiring layer provided on the glass substrate 10 and the TGVs provided in the glass substrate, and therefore a high yield can be achieved. This will be described below.

As described above, as shown in Fig. 2, the wet etching performed in the eighth process produces undercuts in the hydrofluoric acid resistant metal layer 21. In the ninth process of forming the adhesion layer 72 and the seed layer 73, the materials of the adhesion layer 72 and the seed layer 73 are less likely to be deposited in the undercuts compared to the side walls of the first through-holes 12 or regions of the bottom surfaces of the recesses formed in the first conductor layer 20 corresponding to the openings of the first through-holes 12 on the first surface S1 side. Therefore, if the sum $T1+T2$ of the thickness $T1$ of the adhesion layer 72 and the thickness $T2$ of the seed layer 73 is smaller than the thickness $T3$ of the hydrofluoric acid resistant metal layer 21, there is a risk that a seed layer 73 having discontinuities is formed in the vicinities of the undercuts. For example, there is a risk of forming a seed layer 73 having annular discontinuities surrounding the openings of the first through-holes 12 on the first surface S1 side.

If the seed layer 73 has such discontinuities, power cannot be supplied to the portions of the seed layer 73 surrounded by the annular discontinuities during the electrolytic copper plating performed in the tenth process. As a result of this, voids can be produced in the portions between the second copper layer 74 and portions of the seed layer 73 surrounded by the annular discontinuities, at positions of the recesses formed in the first conductor layer 20. That is, disconnection may occur between the wiring layer provided on the glass substrate 10 and the TGVs provided in the glass substrate.

In the method described referring to Figs. 1 to 11, the sum $T1+T2$ of the thickness $T1$ of the adhesion layer 72 and the thickness $T2$ of the seed layer 73 is made greater than or equal to the thickness $T3$ of the hydrofluoric acid resistant metal layer 21. If the adhesion layer 72 and the seed layer 73 are formed to satisfy this relationship, the occurrence of the discontinuities in the seed layer 73 can be reliably prevented. Therefore, the occurrence of the voids can be prevented. Accordingly, disconnection can be made less likely to occur between the wiring layer provided on the glass substrate 10 and the TGVs provided in the glass substrate, and therefore a high yield can be achieved.

In this method, the thickness $T1$ is preferred to be made greater than or equal to the thickness $T3$. If the adhesion layer 72 is formed to satisfy this relationship, the occurrence of the discontinuities in the seed layer 73 can be more reliably prevented.

In this method, the thickness $T2$ is preferred to be made greater than or equal to the sum $T1+T3$ of the thicknesses $T1$ and $T3$. If power supply to the portions of the seed layer 73 at positions in the first through-holes 12 is insufficient when performing electrolytic plating for forming the second copper layer 74, deposition of copper in the first through-holes 12 may become insufficient, due to which, there is a risk of causing disconnection between the wiring layer provided on the glass substrate 10 and the TGVs provided in the glass substrate. If the adhesion layer 72 and seed layer 73 are formed to satisfy the above relationship, disconnection due to insufficient power supply can be made less likely to occur.

<1.5> Modifications

Various modifications can be made to the wiring board 1 and the packaged device described above.

<1.5.1> First through-holes

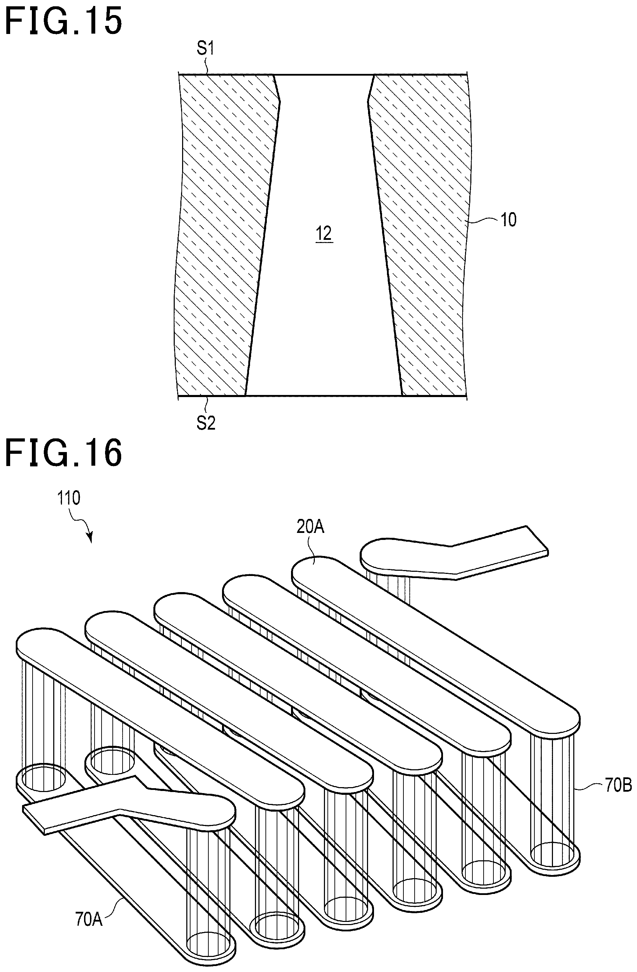

Fig. 14 is a cross-sectional view illustrating a through-hole provided in a glass substrate of a wiring board according to a first modification. Fig. 15 is a cross-sectional view illustrating a through-hole provided in a glass substrate of a wiring board according to a second modification. The wiring boards according to the first and second modifications are similar to the wiring board 1 described above except that the structures shown in Figs. 14 and 15 are adopted for the first through-holes 12.

In the wiring board 1 described above, the through-holes 12 provided in the glass substrate 10 are tapered from the second surface S2 toward the first surface S1. That is, the first through-holes 12 are forward tapered. As shown in Figs. 14 and 15, each first through-holes 12 may include a forward tapered portion in which it is tapered from the second surface S2 toward the first surface S1, and a reverse tapered portion in which it is tapered from the first surface S1 toward the second surface S2.

In this example, the forward tapered portion extends from the second surface S2 toward the first surface S1 while being reduced in diameter from the second surface S2 toward the first surface S1. Also, the reverse tapered portion extends from the first surface S1 toward the second surface S2 while being increased in diameter from the first surface S1 toward the second surface S2.

In the structure shown in Fig. 14, the position where the first through-hole 12 has a minimum diameter is at a position whose distance from the first surface S1 is within the range of 0.4 to 0.6 times the thickness T of the glass substrate 10. In the structure shown in Fig. 15, the position where the first through-hole 12 has a minimum diameter is at a position whose distance from the first surface S1 is 0.2 times or less the thickness T of the glass substrate 10.

In each of the structures shown in Figs. 14 and 15, the position where the first through-hole 12 has a minimum diameter (or the position where the cross sectional area parallel to the first surface S1 is minimum) is spaced apart from the first surface S1. Therefore, if the structure shown in Fig. 14 or 15 is adopted for the first through-holes 12, the stress applied to the connecting portions between the first and second conductor layers 20 and 70 can be reduced compared to the case of adopting the structure shown in Fig. 2, and therefore connection reliability can be further improved between the wiring layer provided on the glass substrate 10 and the TGVs provided in the glass substrate.

<1.5.2> Inductor

The packaged device described above includes an inductor as the chip component 3. As described above, an LC filter can be constituted by combining an inductor with a capacitor 30.

The inductor may be incorporated in the wiring board 1. If the inductor is incorporated in the wiring board 1, the wiring length can be reduced, for example, leading to improvement in electrical characteristics and transmission characteristics, or size reduction or height reduction of the packaged device.

For example, the inductor incorporated in the wiring board 1 may be a helical coil. The wiring board 1 may include a portion of the first conductor layer 20 as a helical coil, or may include a portion of the second conductor layer 70 as a helical coil. Alternatively, the wiring board 1 may include a portion of the first conductor layer 20 as a helical coil, and may include a portion of the second conductor layer 70 as another helical coil.

The wiring board 1 may incorporate a solenoid coil described below as the inductor.

Fig. 16 is a perspective view illustrating part of a wiring board according to a third modification. Fig. 16 illustrates a solenoid coil 110 as an example of the inductor that can be incorporated in the wiring board 1. The wiring board according to the third modification is similar to the wiring board 1 except that it includes the solenoid coil 110.

The solenoid coil 110 is constituted of part of the first conductor layer 20 and part of the second conductor layer 70. Specifically, the solenoid coil 110 includes first conductor paths 20A, second conductor paths 70A, and third conductor paths 70B.

The first conductor paths 20A are parts of the first conductor layer 20. The first conductor paths 20A each have a shape extending in a first direction parallel to the first surface S1, and are arranged at a regular pitch in a second direction parallel to the first surface S1 and intersecting the first direction. Each of the first conductor paths 20A includes a first end and a second end. The first through-holes 12 are provided in the glass substrate 10 at positions of the first ends and the second ends.

The second conductor paths 70A are parts of the second conductor layer 70 in portions located on the second surface S2. The second conductor paths 70A each have a shape parallel to the second surface S2 and extending in a third direction intersecting the first and second directions, and are arranged at a regular pitch in the second direction. Each second conductor path 70A has a third end facing the first end of a first conductor path 20A, and a third end facing the second end of the first conductor path 20A adjacent to the previous first conductor path 20A.

The third conductor paths 70B are parts of the second conductor layer 70 in portions located in the first through-holes 12. The third conductor paths 70B connect the third and fourth ends of second conductor paths 70A to the first end of a first conductor path 20A and the second end of the first conductor path 20A adjacent to the previous first conductor path 20A.

The solenoid coil 110 has a structure in which a plurality of segments are connected in series, each segment including a first conductor path 20A, a third conductor path 70B, a second conductor path 70A, and a third conductor path 70B in this order. The helical axis of the solenoid coil 110 is parallel to the second direction. The solenoid coil 110 constitutes an LC filter in combination with the capacitor 30.

As described above, in the structure described referring to Fig. 13, connection resistance between the first and second conductor layers 20 and 70 is great. Therefore, if the connecting portions between the first and third conductor paths 20A and 70B each have the structure described referring to Fig. 13, connection resistance between the first and third conductor paths 20A and 70B is great. Accordingly, in this case, it is difficult to achieve an LC filter having good electrical characteristics and good transmission characteristics, in particular, good transmission characteristics in the high frequency regions.

In contrast, in the solenoid coil 110 described above, the connecting portions between the first conductor paths 20A and the third conductor paths 70B each have the structure described referring to Fig. 2. In the structure shown in Fig. 2, connection resistance between the first and second conductor layers 20 and 70 is small. Therefore, connection resistance between the first conductor paths 20A and the third conductor paths 70B is small in the solenoid coil 110. Accordingly, if the solenoid coil 110 is combined with the capacitor 30, an LC filter having good electrical characteristics and good transmission characteristics can be achieved.

The solenoid coil 110 is constituted of part of the first conductor layer 20 and part of the second conductor layer 70. A solenoid coil having a similar structure can be constituted of part of the first conductor layer 20 and part of the conductor layer 50, and also can be constituted of part of the second conductor layer 70 and part of the conductor layer 90.

<1.5.3> Thicknesses T1 to T3

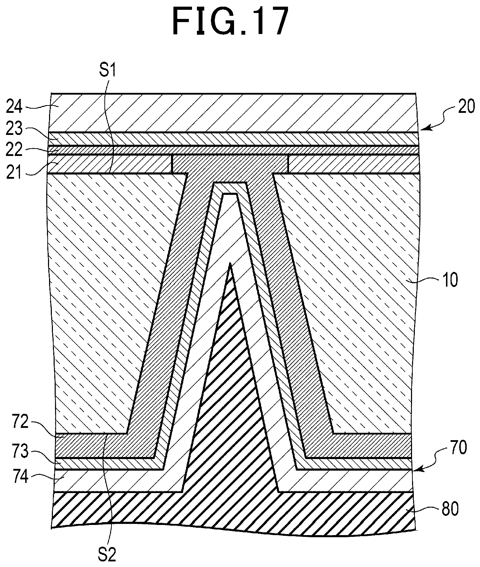

Fig. 17 is a cross-sectional view illustrating part of a wiring board according to a fourth modification. The wiring board according to the fourth modification is similar to the wiring board 1 except that the thicknesses T1 to T3 satisfy the relationship described later.

In the method described referring to Figs. 1 to 11, the second copper layer 74 is formed in the tenth process, and then the entire surface of the composite including the second copper layer 74 and the glass substrate 10 is etched on the second copper layer 74 side to remove the exposed portions of the seed layer 73. By performing this etching, the surface regions of the second copper layer 74 are also removed. Consequently, not only the thickness but also the width of the portions of the second copper layer 74 constituting the wiring are reduced. Therefore, if the thickness of the second copper layer 74 is increased, the shape accuracy and dimensional accuracy of the wiring included in the second conductor layer 70 are deteriorated.

In the structure shown in Fig. 2, the thickness T1 of the adhesion layer 72 is smaller than the thickness T3 of the hydrofluoric acid resistant metal layer 21. Therefore, the seed layer 73 is required to be formed such that the sum T1+T2 of the thickness T1 of the adhesion layer 72 and the thickness T2 of the seed layer 73 becomes greater than or equal to the thickness T3.

In contrast, in the structure shown in Fig. 17, the thickness T1 is greater than the thickness T3 of the hydrofluoric acid resistant metal layer 21. If the thickness T1 of the adhesion layer 72 is made greater than or equal to the thickness T3 of the hydrofluoric acid resistant metal layer 21, the sum T1+T2 of the thickness T1 of the adhesion layer 72 and the thickness T2 of the seed layer 73 can be made greater than or equal to the thickness T3 of the hydrofluoric acid resistant metal layer 21 without increasing the thickness T2 of the seed layer 73. That is, accuracy deterioration in shape and dimension of the wiring included in the second conductor layer 70 can be suppressed, thereby suppressing deterioration in electrical characteristics due to the accuracy deterioration.

<1.5.4> Copper layer

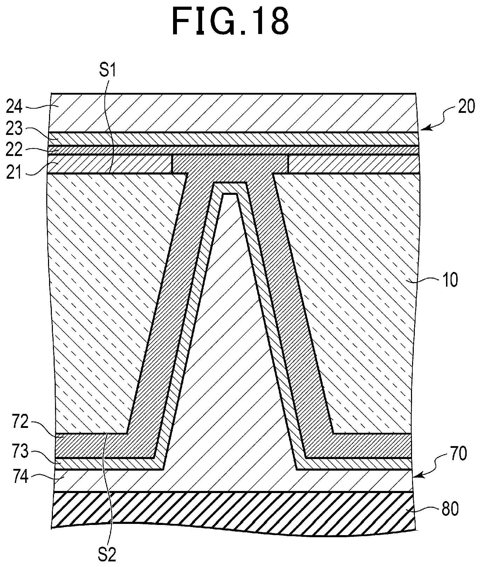

Fig. 18 is a cross-sectional view illustrating part of a wiring board according to a fifth modification. The wiring board according to the fifth modification is similar to the wiring board 1 described above except that the structure described later is adopted for the second copper layer 74.

In the structure shown in Fig. 2, the second copper layer 74 is conformal to the seed layer 73 at positions of the first through-holes 12. In contrast, in the structure shown in Fig. 18, the second copper layer 74 has embedded therein the entirety of the first through-holes 12 in which the adhesion layer 72 and the seed layer 73 are formed on the side walls. That is, the former structure is a conformal form, and the latter structure is a filled form.

In the vias, the copper layer may adopt either of the conformal form and the filled form. If the filled form is adopted, electrical characteristics or transmission characteristics can be improved at connecting portions between the wiring layer provided on the glass substrate 10 and the TGVs provided in the glass substrate, compared to the case of adopting the conformal form.

<1.5.5> Hydrofluoric acid resistant metal layer

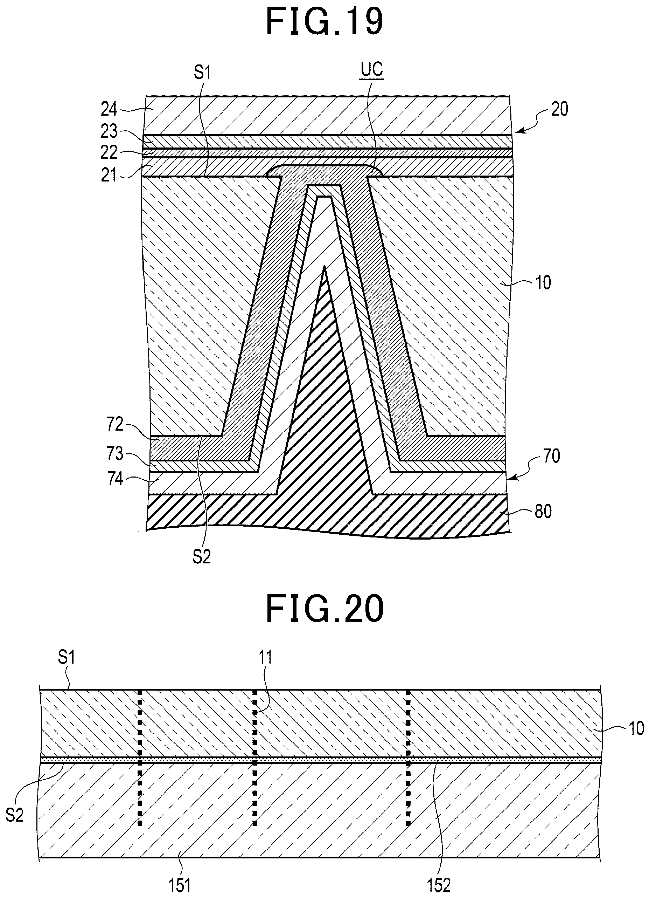

Fig. 19 is a cross-sectional view illustrating part of a wiring board according to a sixth modification. The wiring board according to the sixth modification is similar to the wiring board 1 described above except that the following structure is adopted for the first conductor layer 20.

In the structure shown in Fig. 2, the second through-holes are formed in the hydrofluoric acid resistant metal layer 21 at positions of the first through-holes 12 to form the recesses in the first conductor layer 20 at positions of the first through-holes 12. In contrast, in the structure shown in Fig. 19, the hydrofluoric acid resistant metal layer 21 has recesses at positions of the first through-holes 12. The recesses constitute the recesses of the first conductor layer 20.

If the etching residues 10ER described referring to Fig. 13 can be removed, etching of the hydrofluoric acid resistant metal layer 21 at positions of the first through-holes 12 may be ended prior to producing through-holes in the hydrofluoric acid resistant metal layer 21. If the structure shown in Fig. 19 is adopted, in order to reliably remove the etching residues 10ER, the recesses provided to the hydrofluoric acid resistant metal layer 21 are each preferred to have an average depth D that is 50% or more of the thickness T3 of the portions of the hydrofluoric acid resistant metal layer 21 where the recesses are not provided. The average depth D of a recess provided in the hydrofluoric acid resistant metal layer 21 is an average of measurements using an electron microscope in a cross section taken along a plane passing through the midpoint of a first through-hole 12, performed at at least ten points on the line connecting between the edges of the first surface S1 on both sides of the first through-hole 12, with the distance to the bottom of the recess of the hydrofluoric acid resistant metal layer 21 immediately above the line being assumed to be the depth of the recess and with the measurement intervals being equalized between the edges of the first surface S1.

If the portions of the hydrofluoric acid resistant metal layer 21 corresponding to the respective first through-holes 12 are not completely removed, portions of the hydrofluoric acid resistant metal layer 21 remaining at the respective first through-holes 12 may deteriorate the electrical characteristics or transmission characteristics mentioned above. From the perspective of electrical characteristics or transmission characteristics, the average depth D is preferred to be 70% or more of the thickness T3.
If etching is ended before producing through-holes in the hydrofluoric acid resistant metal layer 21, time required for the etching can be shortened. Considering this effect, the average depth D is preferred to be 90% or less of the depth T3.

<1.5.6> Other modifications

Still other modifications can be made to the wiring board 1 and the packaged device described above.
For example, the wiring board 1 shown in Fig. 1 includes only one laminate of the interlayer insulating film 40 and the conductor layer 50 on the first surface S1. Two or more of such laminates may be laminated on the first surface S1. Alternatively, such a laminate may be omitted.
Similarly, the wiring board 1 shown in Fig. 1 includes only one laminate of the interlayer insulating film 80 and the conductor layer 90 on the second surface S2. Two or more of such laminates may be laminated on the second surface S2. Alternatively, such a laminate may be omitted.

<2> Second Embodiment

A second embodiment of the present invention is similar to the first embodiment except that the wiring board is produced through the following method.

<2.1> Method of producing wiring board

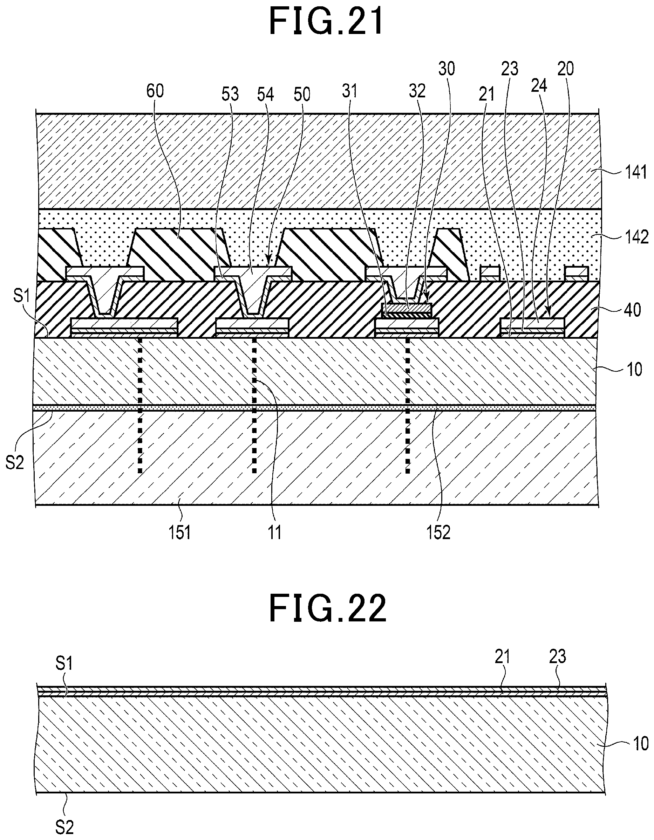

Fig. 20 is a cross-sectional view illustrating a process in a method of producing a wiring board according to the second embodiment of the present invention. Fig. 21 is a cross-sectional view illustrating another process in the method of producing the wiring board according to the second embodiment of the present invention.
As described below, the production method according to the second embodiment is similar to the production method described referring to Figs. 1 to 11 except that a thirteenth process and a fourteenth process are performed instead of the first and second processes and a fifteenth process is performed between the sixth and seventh processes.

<2.1.1> Thirteenth process

In this method, first, a glass substrate 10 having a first surface S1 and a second surface S2 which is the rear of the first surface S1 is prepared. The glass substrate 10 is preferred to have a smaller thickness than that of the substrate used in the first process. For example, contaminants are removed from the surface of a non-alkali glass plate having a thickness of 130 μm by ultrasonic cleaning or the like to obtain a glass substrate 10 . The glass substrate 10 at this stage is a large-sized glass substrate having a larger dimension in the direction perpendicular to the thickness direction, compared to the glass substrate 10 included in a packaged device.

Next, as shown in Fig. 20, a first support 151 is bonded to the second surface S2 via an adhesive 152 for temporary bonding. For example, a thin glass carrier may be used as the first support 151. The first support 151 does not have to be made of glass but may be made of a metal or resin. The first support 151 is preferred to have a thickness in the range of 0.7 mm or more and 10 mm or less from the perspective of transferability of the glass substrate 10. The thickness of the first support 151 may be appropriately determined according to the thickness of the glass substrate 10.

<2.1.2> Fourteenth process

Next, the glass substrate 10 is irradiated with a laser beam from the first surface S1 to the second surface S2 to form one or more modified portions 11 in the glass substrate 10 as shown in Fig. 20. The modified portions 11 are formed at positions corresponding to the first through-holes. The modified portions 11 extend from the first surface S1 to the second surface S2 in the thickness direction, for example, of the glass substrate 10. It is preferred that the laser intensity is adjusted so that the modified portions 11 extending from the first surface S1 can reach the second surface S2 but do not reach the rear of the first support 151 facing away from the second surface S2.

<2.1.3> Third to sixth process

Next, third to sixth processes are sequentially performed for the glass substrate 10 supported by the first support 151. Thus, the structure shown in Fig. 21 is obtained.

<2.1.4> Fifteenth process

After that, the first support 151 and the adhesive 152 are removed from the composite including the glass substrate 10, the first conductor layer 20, the second support 141, etc.

<2.1.5> Seventh to twelfth processes

Furthermore, seventh to twelfth processes are sequentially performed for the composite including the glass substrate 10, the first conductor layer 20, etc. Thus, the wiring board 1 shown in Fig. 1 is obtained.

<2.2> Effects

The second embodiment has effects similar to those of the first embodiment.

In the second embodiment, the modified portions 11 are formed so as to extend from the first surface S1 and reach the second surface S2. Therefore, the modified portions 11 are not varied in length in the glass substrate 10. In this way, according to the second embodiment, variation in diameter of the first through-holes 12 can be easily reduced compared to the first embodiment and higher processing accuracy can be achieved.

<2.3> Modifications

For example, modifications similar to those described in the first embodiment can be made to the above production method, the wiring board obtained from the production method, and the packaged device including the wiring board.

<3> Third Embodiment

A third embodiment of the present invention is similar to the first embodiment except that the wiring board is produced through the following method.

<3.1> Method of producing wiring board

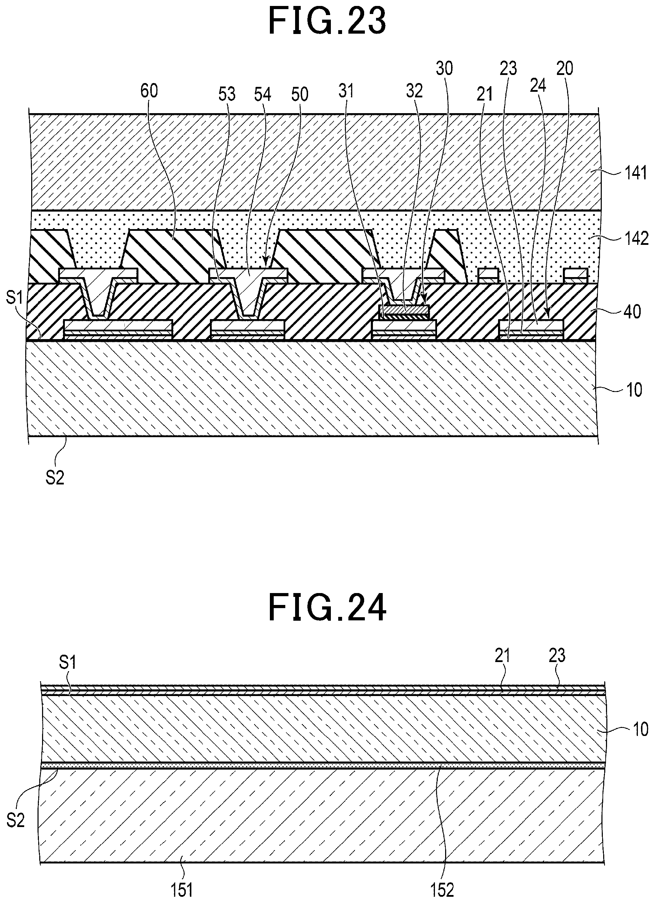

Fig. 22 is a cross-sectional view illustrating a process in a method of producing a wiring board according to the third embodiment of the present invention. Fig. 23 is a cross-sectional view illustrating another process in the method of producing the wiring board according to the third embodiment of the present invention.

As described below, the production method according to the third embodiment is similar to the production method described referring to Figs. 1 to 11 except that the second process is omitted and a sixteenth process is performed between the sixth and seventh processes.

<3.1.1> First, and third to sixth processes

First, the first process is performed, followed by the third process without performing the second process. In the third process, first, the structure shown in Fig. 22 is obtained. The structure shown in Fig. 22 is similar to the structure shown in Fig. 4 except that no modified portions 11 are provided. After that, the remaining processing of the third process is performed, followed by fourth to sixth processes in this order. In this way, the structure shown in Fig. 23 is obtained.

<3.1.2> Sixteenth process

Next, the glass substrate 10 is irradiated with a laser beam from the second surface S2 to the first surface S1 to form one or more modified portions 11 in the glass substrate 10 as shown in Fig. 7. The modified portions 11 are formed at positions corresponding to the first through-holes. The modified portions 11 extend from the first surface S1 to the second surface S2 in the thickness direction, for example, of the glass substrate 10. It is preferred that the laser intensity is adjusted so that the modified portions 11 extending from the first surface S1 do not reach the second surface S2. For example, the laser beam irradiation conditions can be similar to those of the second process.

<3.1.3> Seventh to twelfth processes

Furthermore, seventh to twelfth processes are sequentially performed for the composite including the glass substrate 10, the first conductor layer 20, etc. Thus, the wiring board 1 shown in Fig. 1 is obtained.

<3.2> Effects

The third embodiment has effects similar to those of the first embodiment.

<3.3> Modifications

For example, modifications similar to those described in the first embodiment can be made to the above production method, the wiring board obtained from the production method, and the packaged device including the wiring board.

<4> Fourth Embodiment

A fourth embodiment of the present invention is similar to the first embodiment except that the wiring board is produced through the following method.

<4.1> Method of producing wiring board

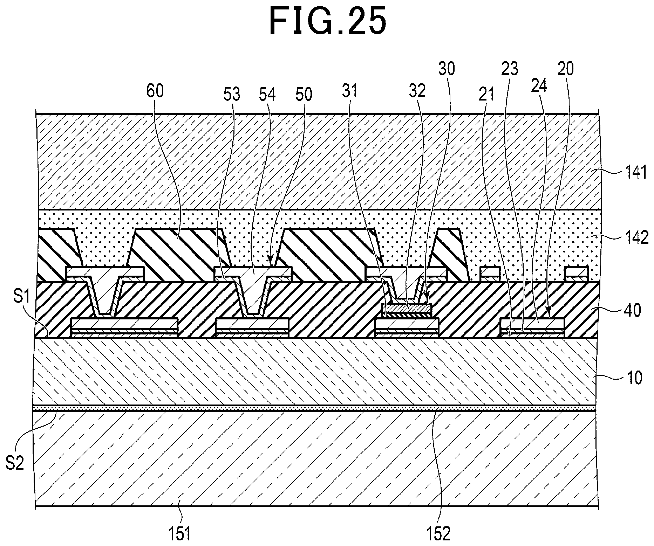

Fig. 24 is a cross-sectional view illustrating a process in a method of producing a wiring board according to the fourth embodiment of the present invention. Fig. 25 is a cross-sectional view illustrating another process in the method of producing the wiring board according to the fourth embodiment of the present invention.

As described below, the production method according to the fourth embodiment is similar to the production method described referring to Figs. 1 to 11 except that a thirteenth process is performed instead of the first process, the second process is omitted, and a seventeenth process and the fifteenth process are performed in this order between the sixth and seventh processes.

<4.1.1> Thirteenth, and third to sixth processes

First, the thirteenth process is performed instead of the first process, followed by the third process without performing the second process. In the third process, first, the structure shown in Fig. 24 is obtained. The structure shown in Fig. 24 is similar to the structure shown in Fig. 20 except that no modified portions 11 are provided, and a hydrofluoric acid resistant metal layer 21 and a seed layer 23 are formed in this order on the first surface S1. After that, the remaining processing of the third process is performed, followed by fourth to sixth processes in this order. In this way, the structure shown in Fig. 25 is obtained.

<4.1.2> Seventeenth process

Next, the glass substrate 10 is irradiated with a laser beam from the second surface S2 to the first surface S1 to form one or more modified portions 11 in the glass substrate 10 as shown in Fig. 21. The modified portions 11 are formed at positions corresponding to the first through-holes. The modified portions 11 extend from the first surface S1 to the second surface S2 in the thickness direction, for example, of the glass substrate 10. It is preferred that the laser intensity is adjusted so that the modified portions 11 extending from the first surface S1 do not reach the second surface S2. For example, the laser beam irradiation conditions can be similar to those of the second process.

<4.1.3> Fifteenth, and seventh to twelfth processes

Next, by performing the fifteenth process, the first support 151 and the adhesive 152 are removed from the composite including the glass substrate 10, the first conductor layer 20, the second support 141, etc. After that, the seventh to twelfth processes are sequentially performed for the composite including the glass substrate 10, the first conductor layer 20, etc. Thus, the wiring board 1 shown in Fig. 1 is obtained.

<4.2> Effects

The fourth embodiment has effects similar to those of the first and second embodiments.

<4.3> Modifications

For example, modifications similar to those described in the first embodiment can be made to the above production method, the wiring board obtained from the production method, and the packaged device including the wiring board.

Examples

Hereinafter, tests performed in connection with the present invention will be described.

<Test 1>

For each of the structures of Figs. 2, 19 and 13, the relationship between the electrical resistance between the wiring layers respectively included in the first and second conductor layers 20 and 70, and the length of the through-electrodes was determined. The layers were equal in thickness between the structures. The sum T1+T2 of the thickness T1 of the adhesion layer 72 and the thickness T2 of the seed layer 73 was made greater than the thickness T3 of the hydrofluoric acid resistant metal layer 21. For the structure shown in Fig. 19, the above relationship was determined in the case where the average depth D of each recess provided to the hydrofluoric acid resistant metal layer 21 was 40% of the thickness T3 of the hydrofluoric acid resistant metal layer 21 at the portion where the recess was not provided, and also in the case where the average depth D was 70% of the thickness T3. Table 1 below shows the results.

[Table 1]

| | | Resistance reduction ratio (%) | | | |
|---|---|---|---|---|---|
| Etching ratio | | 0% | 40% | 70% | 100% |
| Length of through-electrode ($\mu$m) | 100 | 0 | -1.2 | -2.2 | -3.2 |
| | 80 | 0 | -1.5 | -2.7 | -3.9 |
| | 60 | 0 | -2.0 | -3.6 | -5.3 |
| | 50 | 0 | -2.4 | -4.3 | -6.3 |

In Table 1, etching ratio represents ratio of the average depth D to the thickness T3. That is, the structure where the etching ratio is 100% is the structure shown in Fig. 2, the structure where the etching ratio is 0% is the structure shown in Fig. 13, and the structure where the etching ratio is 40% or 70% is the structure shown in Fig. 19. Also, resistance reduction ratio represents reduction ratio of electrical resistance to electrical resistance in the case of the etching ratio being 0%.

As shown in Table 1, regardless of the length of the through-electrodes , resistance reduction effect increased with the increase of the etching ratio. Also, the shorter the length of the through-electrodes , the higher the resistance reduction effect accompanying the increase in etching ratio.

<Test 2>

For the wiring boards each having a structure similar to the wiring board 1 shown in Fig. 1 except that the solenoid coil 110 of Fig. 16 was incorporated and the LC filter was constituted of the capacitor 30 and the solenoid coil 110, Q-values of the capacitor 30 and the solenoid coil 110, and S-parameters S21 of the resonant frequency of the LC filter were determined. The length of the through-electrodes , i.e., the length of the first through-holes 12, was 100 $\mu$m. For wiring boards each having a structure similar to the above wiring board except that the etching ratios were 75%, 50% and 0%, Q-values of the capacitor 30 and the solenoid coil 110, and S parameters S21 of the resonant frequency of the LC filter were also determined. Table 2 below shows the results.

[Table 2]

| Etching ratio | | 0% | 50% | 75% | 100% |
|---|---|---|---|---|---|
| Capacitor | Q-value increase ratio (%) | 0 | 0.1 | 0.7 | 4.5 |
| Inductor | | 0 | 1.1 | 8.7 | 16.4 |
| LC filter | S21-value reduction ratio of resonant frequency (%) | 0 | -0.1 | -0.3 | -0.6 |

In Table 2, Q-value increase ratio represents increase ratio of Q-value to Q-value in the case of the etching ratio being 0%. Also, S21-value reduction ratio represents reduction ratio of S21 value to S21 value in the case of the etching ratio being 0%.

As shown in Table 2, the more the etching ratio was increased, the more the Q-values of the capacitor 30 and the solenoid coil 110 increased, and thus the effect of increasing the Q-values accompanying the increase in etching ratio was higher as the etching ratio was increased. Also, the S21-values of the LC filters decreased as the etching ratio was increased, and thus the effect of improving filter characteristics accompanying the increase in etching ratio was higher as the etching ratio was increased.

<Test 3>

50 wiring boards 1 described referring to Figs. 1 and 2 were prepared (etching ratio: 100%). For each of these wiring boards 1, connection reliability between the wiring layer provided on the glass substrate 10 and the through-electrodes was determined. Specifically, each wiring board 1 was attached to a thermal shock tester, and a cycle of varying the ambient temperature of the wiring board from -40°C to +125°C was repeated 1,000 times. After that, electrical continuity between the wiring layer and the through-electrodes was determined. The electrical continuity between the wiring layer and the through-electrodes was determined by measuring the electrical resistance between the wiring layers included in the first and second conductor layers 20 and 70 using a tester.

50 wiring boards similar to the above were prepared except that each of them adopted the structure shown in Fig. 19 instead of the structure shown in Fig. 2. The etching ratio was 70%. For each of these wiring boards also, connection reliability between the wiring layer provided on the glass substrate 10 and the through-electrodes was determined.

50 wiring boards similar to the above were prepared except that each of them adopted the structure shown in Fig. 13 instead of the structure shown in Fig. 2 (etching ratio: 0%). For each of these wiring boards also, connection reliability between the wiring layer provided on the glass substrate 10 and the through-electrodes was determined.

Consequently, it was revealed that the wiring boards adopting the structure shown in Fig. 13 (etching ratio: 0%) caused conduction failures at a frequency of 30%. In contrast, the wiring boards adopting the structure shown in Fig. 19 (etching ratio: 70%) caused conduction failures at a ratio of 3% or less. The wiring boards adopting the structure shown in Fig. 2 (etching ratio: 100%) caused conduction failures at a ratio of 1% or less.

<Test 4>

(Example 1)

50 wiring boards 1 described referring to Figs. 1 and 2 were prepared (etching ratio: 100%). The thickness $T_1$ of the adhesion layer 72 was 60 nm, the thickness $T_2$ of the seed layer 73 was 300 nm, and the thickness $T_3$ of the hydrofluoric acid resistant metal layer 21 was 50 nm. For each of these wiring boards 1, electrical continuity between the wiring layer provided on the glass substrate 10 and the through-electrodes was determined. The electrical continuity between the wiring layer and the through-electrodes was determined by measuring the electrical resistance between the wiring layers included in the first and second conductor layers 20 and 70 using a tester.

(Example 2)

50 wiring boards 1 were prepared as in Example 1 except that the thickness $T_3$ was changed to 100 nm. For each of these wiring boards 1 also, electrical continuity between the wiring layer provided on the glass substrate 10 and the through-electrodes was determined in a manner similar to Example 1.

(Example 3)

50 wiring boards 1 were prepared as in Example 1 except that the thickness $T_2$ was changed to 100 nm and the thickness $T_3$ was changed to 50 nm. For each of these wiring boards 1 also, electrical continuity between the wiring layer provided on the glass substrate 10 and the through-electrodes was determined in a manner similar to Example 1.

(Example 4)

50 wiring boards 1 were prepared as in Example 1 except that the thickness $T_2$ was changed to 100 nm and the thickness $T_3$ was changed to 100 nm. For each of these wiring boards 1 also, electrical continuity between the wiring layer provided on the glass substrate 10 and the through-electrodes was determined in a manner similar to Example 1.

(Comparative Example)

50 wiring boards were prepared as in Example 1 except that the thickness $T_2$ was changed to 100 nm and the thickness $T_3$ was changed to 200 nm. For each of these wiring boards also, electrical continuity between the wiring layer provided on the glass substrate 10 and the through-electrodes was determined in a manner similar to Example 1.

(Results)

Table 3 below shows the results.

[Table 3]

| | Ex. 1 | Ex. 2 | Ex. 3 | Ex. 4 | Comp. Ex. |
|---|---|---|---|---|---|
| Thickness $T_3$ of hydrofluoric acid resistant metal layer (nm) | 50 | 100 | 50 | 100 | 200 |
| Thickness $T_1$ of adhesion layer (nm) | 60 | 60 | 60 | 60 | 60 |
| Thickness $T_2$ of seed layer (nm) | 300 | 300 | 100 | 100 | 100 |
| $T_3 \leq T_1$ | Y | N | Y | N | N |
| $T_3 \leq T_1 + T_2$ | Y | Y | Y | Y | N |
| $T_1 + T_3 \leq T_2$ | Y | Y | N | N | N |
| Pass rate (%) | 100 | 100 | 80 | 80 | 20 |

In Table 3, Y represents that the relationships shown in the inequalities are satisfied, and N represents that the relationships shown in the inequalities are not satisfied. Pass rate represents a rate of the number of wiring boards caused no conduction failures, relative to the total number (50) of the wiring boards.

As shown in Table 3, much higher pass rate could be achieved in the case of the sum $T_1 + T_2$ of the thicknesses $T_1$ and $T_2$ being greater than or equal to the thickness $T_3$, than in the case of the sum $T_1 + T_2$ being smaller than the thickness $T_3$. In addition, a pass rate of 100% could be achieved in the case of the thickness $T_2$ being greater than the sum $T_1 + T_3$ of the thicknesses $T_1$ and $T_3$.

[Reference Signs List]

| | |
|---|---|
| 1 | Wiring board |
| 2 | Functional device |
| 3 | Chip component |
| 4 | Bonding conductor |
| 5 | Bonding conductor |
| 10 | Glass substrate |
| 10ER | Etching residues |
| 11 | Modified portion |
| 12 | First through-hole |
| 20 | First conductor layer |
| 20A | First conductor path |
| 21 | Hydrofluoric acid resistant metal layer |
| 22 | Adhesion layer |
| 23 | Seed layer |
| 24 | First copper layer |
| 30 | Capacitor |
| 31 | Dielectric layer |
| 32 | Upper electrode |
| 40 | Interlayer insulating film |
| 50 | Conductor layer |
| 53 | Seed layer |
| 54 | Copper layer |
| 60 | Insulating layer |
| 70 | Second conductor layer |
| 70A | Second conductor path |
| 70B | Third conductor path |
| 72 | Adhesion layer |

**EP 4 593 537 A1**

| 73 | Seed layer |
|----|-----------|
| 74 | Second copper layer |
| 80 | Interlayer insulating film |
| 90 | Conductor layer |
| 93 | Seed layer |
| 94 | Copper layer |
| 100 | Insulating layer |
| 110 | Solenoid coil |
| 141 | Second support |
| 142 | Adhesive |
| 151 | First support |
| 152 | Adhesive |
| S1 | First surface |
| S2 | Second surface |
| UC | Undercut |

**Claims**

1.  A wiring board comprising

    a glass substrate having a first surface and a second surface, which is to a rear of the first surface, and provided with one or more first through-holes each extending from the first surface to the second surface;
    a first conductor layer including a first copper layer facing the first surface, and a hydrofluoric acid resistant metal layer interposed between the first copper layer and the glass substrate and covering openings of the one or more first through-holes on the first surface side, the first conductor layer having recesses in a surface thereof at positions of the one or more first through-holes on the glass substrate side, each of the recesses having an opening whose contour is wider than and surrounding the opening of a corresponding one of the one or more first through-holes on the first surface side; and
    a second conductor layer including an adhesion layer covering the side walls of the one or more first through-holes, inner surfaces of the recesses, and regions of the second surface surrounding openings of the one or more first through-holes on the second surface side, a seed layer provided on the adhesion layer, and a second copper layer provided on the seed layer, wherein
    a sum T1+T2 of a thickness T1 of the adhesion layer and a thickness T2 of the seed layer is greater than or equal to a thickness T3 of the hydrofluoric acid resistant metal layer.

2.  The wiring board according to claim 1, wherein the hydrofluoric acid resistant metal layer is provided with one or more second through-holes at positions of the one or more first through-holes, and the one or more second through-holes form the recesses in the surface of the first conductor layer on the glass substrate side.

3.  The wiring board according to claim 1 or 2, wherein the thickness T1 is greater than or equal to the thickness T3.

4.  The wiring board according to any one of claims 1 to 3, wherein the thickness T2 is greater than or equal to a sum T1+T3 of the thickness T1 and the thickness T3.

5. The wiring board according to any one of claims 1 to 4, wherein the thickness T2 is 0.5 $\mu$m or less.

6. The wiring board according to any one of claims 1 to 5, wherein the thickness T1 is in a range of 10 nm to 0.5 $\mu$m, the thickness T2 is in a range of 100 nm to 0.5 $\mu$m, and the thickness T3 is in a range of 10 nm to 0.5 $\mu$m.

7. The wiring board according to any one of claims 1 to 6, further comprising a dielectric layer provided on the first conductor layer, and an upper electrode provided on the dielectric layer, wherein a portion of the first conductor layer facing the upper electrode serves as a lower electrode, and the upper electrode, the dielectric layer, and the lower electrode constitute a capacitor.

8. The wiring board according to claim 7, wherein the lower electrode covers at least one opening of the one or more first through-holes on the first surface side.

9. The wiring board according to any one of claims 1 to 6, wherein

the wiring board further includes a dielectric layer provided on the first conductor layer, and an upper electrode provided on the dielectric layer, a portion of the first conductor layer facing the upper electrode serves as a lower electrode, and the upper electrode, the dielectric layer, and the lower electrode constitute a capacitor;
the one or more first through-holes are a plurality of first through-holes, and part of the first conductor layer and part of the second conductor layer constitute a solenoid coil; and
the capacitor and the solenoid coil constitute an LC filter.

10. The wiring board according to any one of claims 1 to 9, wherein the wiring board serves as an interposer.

11. A method of producing a wiring board, comprising

preparing a glass substrate having a first surface and a second surface which is to a rear of the first surface;
irradiating the glass substrate with a laser beam to form one or more modified portions in the glass substrate;
forming a first conductor layer on the first surface, the first conductor layer including a first copper layer facing the first surface, and a hydrofluoric acid resistant metal layer interposed between the first copper layer and the glass substrate to cover the one or more modified portions;
etching the second surface using an etching solution containing hydrogen fluoride to form recesses in the second surface and form one or more first through-holes at positions of the one or more modified portions;
subjecting portions of the hydrofluoric acid resistant metal layer exposed in the one or more first through-holes to wet etching to form recesses in a surface of the first conductor layer on the glass substrate side;
forming an adhesion layer covering side walls of the one or more first through-holes, inner surfaces of the recesses, and the second surface;
forming a seed layer on the adhesion layer; and
forming a second copper layer on the seed layer, wherein
the adhesion layer, the seed layer, and the hydrofluoric acid resistant metal layer are formed so that a sum T1+T2 of a thickness T1 of the adhesion layer and a thickness T2 of the seed layer is greater than or equal to a thickness T3 of the hydrofluoric acid resistant metal layer.

12. The method of producing a wiring board according to claim 11, further comprising

allowing a first support to support the glass substrate so that the second surface faces the first support, prior to irradiating the glass substrate with the laser beam; and
removing the first support from the glass substrate after forming the first conductor layer but before forming the one or more first through-holes.

13. The method of producing a wiring board according to claim 11 or 12, wherein the wet etching for the hydrofluoric acid resistant metal layer is performed so that one or more second through-holes are formed in the hydrofluoric acid resistant metal layer.

14. The method of producing a wiring board according to any one of claims 11 to 13, further comprising allowing a second support to support a composite including the glass substrate and the first conductor layer so that the first conductor layer faces the second support, after forming the first conductor layer but before forming the one or more first through-holes.

# FIG.1

# FIG.2

# FIG.3

S1

11

S2

10

# FIG.4

S1

11

21    23

S2

10

# FIG.5

S1

11

31  32  30

21  23  24  20

S2

10

# FIG.6

# FIG.7

# FIG.8

# FIG.9

# FIG.10

# FIG.11

# FIG.12

# FIG.13

S1    10ER

24

23
22
21

20

10

72
73
74

70

80

S2

# FIG.14

S1

12

10

S2

# FIG.15

# FIG.16

# FIG.17

# FIG.18

# FIG.19

# FIG.20

# FIG.21

# FIG.22

# FIG.23

60  53  54  50  31  32  30  23  20
                                21  24

141

142

S1

40

10

S2

# FIG.24

S1                                    21    23

10

S2

151                        152

# FIG.25

## INTERNATIONAL SEARCH REPORT

International application No.

**PCT/JP2023/029603**

### A. CLASSIFICATION OF SUBJECT MATTER

***H05K 1/11***(2006.01)i; ***H01L 23/12***(2006.01)i; ***H01L 23/15***(2006.01)i; ***H05K 1/16***(2006.01)i; ***H05K 3/00***(2006.01)i
FI: H05K1/11 H; H05K3/00 M; H05K1/16 A; H01L23/12 N; H01L23/14 C

According to International Patent Classification (IPC) or to both national classification and IPC

### B. FIELDS SEARCHED

Minimum documentation searched (classification system followed by classification symbols)

H05K1/11; H01L23/12; H01L23/15; H05K1/16; H05K3/00; H05K3/46

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | WO 2021/100696 A1 (TOPPAN PRINTING CO LTD) 27 May 2021 (2021-05-27) paragraphs [0036]-[0037], [0043]-[0044], [0050]-[0052], fig. 15-21 | 1-14 |
| Y | JP 2015-038962 A (SONY CORP) 26 February 2015 (2015-02-26) paragraphs [0059]-[0060], [0064]-[0066], [0070] | 1-14 |
| Y | JP 7067666 B1 (TOPPAN PRINTING CO LTD) 16 May 2022 (2022-05-16) paragraphs [0014]-[0027], fig. 1-6 | 12 |
| A | WO 2019/235617 A1 (TOPPAN PRINTING CO LTD) 12 December 2019 (2019-12-12) entire text, all drawings | 1-14 |
| A | JP 2022-032990 A (ZHUHAI ACCESS SEMICONDUCTOR CO LTD) 25 February 2022 (2022-02-25) entire text, all drawings | 1-14 |
| P, A | WO 2022/203037 A1 (TOPPAN PRINTING CO LTD) 29 September 2022 (2022-09-29) entire text, all drawings | 1-14 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **17 October 2023** | **31 October 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/029603**

| Patent document cited in search report | | | Publication date (day/month/year) | Patent family member(s) | | | Publication date (day/month/year) |
|---|---|---|---|---|---|---|---|
| WO | 2021/100696 | A1 | 27 May 2021 | US | 2022/0279651 | A1 | |
| | | | | paragraphs [0107]-[0109], [0123]-[0127], [0135]-[0142], fig. 15-21 | | | |
| | | | | EP | 4064803 | A1 | |
| | | | | CN | 114731761 | A | |
| JP | 2015-038962 | A | 26 February 2015 | US | 2015/0021081 | A1 | |
| | | | | paragraphs [0074]-[0075], [0079]-[0081], [0085] | | | |
| | | | | CN | 104299916 | A | |
| JP | 7067666 | B1 | 16 May 2022 | WO | 2023/100586 | A1 | |
| WO | 2019/235617 | A1 | 12 December 2019 | US | 2021/0118698 | A1 | |
| | | | | entire text, all drawings | | | |
| | | | | EP | 3806141 | A1 | |
| | | | | CN | 112335037 | A | |
| JP | 2022-032990 | A | 25 February 2022 | US | 2022/0053644 | A1 | |
| | | | | entire text, all drawings | | | |
| | | | | KR | 10-2022-0021864 | A | |
| | | | | TW | 202207413 | A | |
| WO | 2022/203037 | A1 | 29 September 2022 | JP | 2022-151790 | A | |
| | | | | JP | 2022-151789 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000061667 A
- JP 2001105398 A
- JP 54126215 A
- WO 2019235617 A
- JP 2021166257 A